# EUROPEAN PATENT APPLICATION

(11) **EP 4 521 146 A1**
(43) Date of publication of application: **12.03.2025**
(21) Application number: 23799502.2
(22) Date of filing: 01.05.2023
(51) Int. Cl.: G02B 6/12, G02B 6/124, G02B 6/126, H01L 31/0232, H01L 31/10

(54) **PHOTODETECTION DEVICE AND LIGHT RECEIVER**

(30) Priority: 06.05.2022 JP 2022076677
(71) Applicant: Kyocera Corporation, Kyoto-shi, Kyoto 612-8501 (JP)
(72) Inventor: UEMURA, Hirotaka, Kyoto-shi, Kyoto 612-8501 (JP)
(74) Representative: Viering, Jentschura & Partner mbB Patent- und Rechtsanwälte
(86) International application number: PCT/JP2023/017092
(87) International publication number: WO 2023/214573

(57) **Abstract**

Provided is an optical detection device that includes a light-receiving waveguide and a light-receiving unit. The light-receiving waveguide is connected to a first input waveguide to which a first optical signal is input and a second input waveguide to which a second optical signal is input. The light-receiving unit is configured to output an electrical signal corresponding to an intensity of a signal obtained by combining the first optical signal and the second optical signal input to the light-receiving waveguide. The light-receiving unit is configured to reduce an intensity of an optical signal returning in an opposite direction from a first direction in which the first optical signal propagates in the first input waveguide, and an intensity of an optical signal returning in an opposite direction from a second direction in which the second optical signal propagates in the second input waveguide.

## Description

### CROSS-REFERENCE TO RELATED APPLICATIONS

This application claims priority of Japanese Patent Application No. 2022-76677 (filed May 6, 2022), the entire disclosure of which is hereby incorporated by reference.

### TECHNICAL FIELD

The present disclosure relates to an optical detection device and an optical receiver.

### BACKGROUND OF INVENTION

A known optical receiver is configured to separate different polarization components into two waveguides, split the light in each waveguide into light of each wavelength, and detect light of a specific wavelength split in each waveguide using a single photodetector (see, for example, Patent Literature 1).

### CITATION LIST

### PATENT LITERATURE

Patent Literature 1: Specification of US Patent No. 10,488,593

### SUMMARY

In an embodiment of the present disclosure, an optical detection device includes a light-receiving waveguide and a light-receiving unit. The light-receiving waveguide is connected to a first input waveguide to which a first optical signal is input and a second input waveguide to which a second optical signal is input. The light-receiving unit is configured to output an electrical signal corresponding to an intensity of a signal obtained by combining the first optical signal and second optical signal input to the light-receiving waveguide. The light-receiving unit is configured to reduce an intensity of an optical signal returning in an opposite direction from a first direction in which the first optical signal propagates in the first input waveguide, and an intensity of an optical signal returning in an opposite direction from a second direction in which the second optical signal propagates in the second input waveguide.

In an embodiment of the present disclosure, an optical receiver includes an optical circuit and an optical detection device. The optical circuit is configured to separate an input optical signal into a first optical signal propagating in a TE mode and a second optical signal propagating in a TM mode. The optical detection device is configured to output an electrical signal corresponding to an intensity of the first optical signal and the second optical signal input from the optical circuit. The optical detection device includes a light-receiving waveguide and a light-receiving unit. The light-receiving waveguide is connected to a first input waveguide to which the first optical signal is input and a second input waveguide to which the second optical signal is input. The light-receiving unit is configured to output an electrical signal corresponding to an intensity of a signal obtained by combining the first optical signal and second optical signal input to the light-receiving waveguide. The light-receiving unit is configured to reduce an intensity of an optical signal returning in an opposite direction from a first direction in which the first optical signal propagates in the first input waveguide, and an intensity of an optical signal returning in an opposite direction from a second direction in which the second optical signal propagates in the second input waveguide.

### BRIEF DESCRIPTION OF THE DRAWINGS

FIG. 1 is a block diagram illustrating an example configuration of an optical receiver according to an embodiment.
FIG. 2 is a plan view illustrating an example configuration of a photodiode according to an embodiment.
FIG. 3 is an example of a sectional view taken along A-A in FIG. 2.
FIG. 4 is another example of a sectional view taken along A-A in FIG. 2.
FIG. 5 is a plan view illustrating the configuration of a photodiode according to a comparative example.
FIG. 6 is a block diagram illustrating the configuration of an optical receiver according to a comparative example.
FIG. 7 is a plan view illustrating an example configuration of a photodiode in a case where the normal directions of side surfaces of the photodiode are inclined with respect to the direction of travel of light in the example configuration in FIG. 2.
FIG. 8 is a plan view illustrating an example configuration of a photodiode in a case where side surfaces of the photodiode include protrusions in the example configuration in FIG. 2.
FIG. 9 is a plan view illustrating an example configuration of a photodiode in a case where side surfaces of the photodiode include protrusions and axes of the protrusions are inclined with respect to the direction of travel of light in the example configuration in FIG. 2.
FIG. 10 is a plan view illustrating an example configuration of a photodiode in which the direction of travel of light in a first waveguide and the direction of travel of light in a second waveguide are perpendicular to each other.
FIG. 11 is a plan view illustrating an example configuration in which the direction of travel of light in a first waveguide and the direction of travel of light in a second waveguide are perpendicular to each other and the normal directions of side surfaces of the photodiode are inclined with respect to the direction of travel of light.
FIG. 12 is a plan view illustrating an example configuration in which the direction of travel of light in a first waveguide and the direction of travel of light in a second waveguide are perpendicular to each other and side surfaces of the photodiode include protrusions.
FIG. 13 is a plan view illustrating an example configuration in which the direction of travel of light in a first waveguide and the direction of travel of light in a second waveguide are perpendicular to each other, side surfaces of the photodiode include protrusions, and the axes of the protrusions are inclined with respect to the direction of travel of light.
FIG. 14 is a plan view illustrating an example configuration of a photodiode in which a first waveguide and a second waveguide are connected to each other so that multimode interference is generated in a light-receiving waveguide.
FIG. 15 is a plan view illustrating an example of an intensity distribution of light appearing due to multimode interference in a light-receiving waveguide when no light-receiving unit is disposed in the light-receiving waveguide.
FIG. 16 is a plan view illustrating an example of an intensity distribution of light when the size of a light-receiving unit is set so that the intensity of light that propagates to a second waveguide, out of light incident from a first waveguide, is reduced to less than a prescribed intensity.
FIG. 17 is a plan view illustrating an example of an intensity distribution of light when the intensity of light that propagates to a second waveguide, out of light incident from a first waveguide, is greater than or equal to a prescribed intensity by changing the size of a light-receiving unit.
FIG. 18 is a plan view illustrating an example configuration of a photodiode in a case where the direction of travel of light in a first waveguide and the direction of travel of light in a second waveguide are perpendicular to each other, and the first waveguide and the second waveguide are connected to each other so that multimode interference is generated in a light-receiving waveguide.
FIG. 19 is a plan view illustrating an example configuration of a photodiode in a case where the photodiode further includes a terminating waveguide at each of an end on the opposite side from the side where a first waveguide is connected and at an end on the opposite side from the side where a second waveguide is connected in the example configuration in FIG. 18.
FIG. 20 is a plan view illustrating an example configuration of a photodiode in a case where cutouts are formed at each of a side where a first waveguide is connected and a side where a second waveguide is connected in the example configuration in FIG. 19.
FIG. 21 is a plan view illustrating an example configuration of a photodiode in a case where the distance from an end of a light-receiving waveguide to which a first waveguide is connected to a light-receiving unit and the distance from an end of the light-receiving waveguide to which a second waveguide is connected to the light-receiving unit are different from each other.
FIG. 22 is a plan view illustrating an example configuration of a photodiode in a case where the photodiode further includes terminating waveguides at each of an end on the opposite side from the side where a first waveguide is connected and at an end on the opposite side from the side where a second waveguide is connected in the example configuration in FIG. 21.
FIG. 23 is a plan view illustrating an example configuration of a photodiode in a case where cutouts are formed at each of a side where a first waveguide is connected and a side where a second waveguide is connected in the example configuration in FIG. 22.
FIG. 24 is a plan view illustrating an example configuration of a photodiode in a case where the normal directions of side surfaces of the photodiode are inclined with respect to the direction of travel of light in the example configuration in FIG. 14.
FIG. 25 is a plan view illustrating an example configuration of a photodiode in a case where side surfaces of the photodiode include protrusions in the example configuration in FIG. 14.
FIG. 26 is a plan view illustrating an example configuration of a photodiode in a case where side surfaces of the photodiode include protrusions and axes of the protrusions are inclined with respect to the direction of travel of light in the example configuration in FIG. 14.
FIG. 27 is a plan view illustrating an example configuration of a photodiode in a case where the optical axes of a first waveguide and a second waveguide and an optical axis extending through a light-receiving unit are offset from each other in the example configuration in FIG. 14.
FIG. 28 is a block diagram illustrating an example configuration of an optical receiver including an edge coupler as an input unit.
FIG. 29 is a block diagram illustrating an example configuration of an optical receiver including a two-dimensional grating coupler as an input unit.
FIG. 30 is a block diagram illustrating an example configuration of an optical receiver further including delayers in the example configuration in FIG. 28.
FIG. 31 is a block diagram illustrating an example configuration of an optical receiver when a polarizing splitter rotator is replaced with a polarizing splitter in the example configuration in FIG. 30.
FIG. 32 is a block diagram illustrating an example configuration of an optical receiver when delayers connected before the photodiodes is replaced with variable attenuators in the example configuration in FIG. 30.
FIG. 33 is a block diagram illustrating an example configuration of an optical receiver further including delayers between the photodiodes and variable attenuators connected before the photodiodes in the example configuration in FIG. 32.

### DESCRIPTION OF EMBODIMENTS

When light is to be input to a single photodetector from two waveguides, the two waveguides are connected to the photodetector. In the photodetector to which the two waveguides are connected, light that has propagated to the photodetector from one waveguide may pass through the photodetector and propagate as return light in the opposite direction from the input direction in the other waveguide. When a photodetector is used in an optical communication system, return light can destabilize the optical communication system and reduce the reliability of the optical communication system. In an embodiment of the present disclosure, an optical detection device and an optical receiver can improve the reliability of an optical communication system.

Direct-modulation direct-detection methods are widely used in optical communication in data centers due to the convenience and low power consumption of digital signal processors. On the other hand, as the amount of optical communication traffic in data centers increases, higher-density data transmission is required, and optical transceivers including silicon-based optical integrated circuits, in particular, compact wavelength-division multiplexing optical circuits, are being considered. Here, a series Mach-Zehnder interference system or arrayed waveguide gratings can be used as wavelength-division multiplexing optical circuits realized using silicon. All of these wavelength-division multiplexing optical circuits are characterized by the fact that their characteristics vary greatly depending on the polarization of light. On the other hand, single-mode optical fibers are widely used in existing optical fiber networks in data centers. However, this type of optical fiber does not have polarization-maintaining characteristics. Therefore, the polarization of light changes randomly each time light passes through curved portions or connecting portions of wiring. Therefore, in order to ensure that the characteristics of an optical receiver are uniform regardless of the polarization, a polarizing splitter rotator needs to be provided in a former stage of the optical circuit, and the incident light needs to be split into TE (transverse electric) and TM (transverse magnetic) components, and each of these components needs to be input into a separate wavelength-division multiplexing optical circuit. In a direct-modulation direct-polarization method, after the light is polarized to either TE or TM, the outputs of a wavelength multiplexing optical circuit are received by photodiodes and the sum of the outputs of the photodiodes corresponding to the respective polarization components needs to be detected.

In the direct-modulation direct-detection method, when germanium photodiodes are used, a photodiode that detects a TE polarization component and a photodiode that detects a TM polarization component are provided separately in order to detect the sum of the outputs of the photodiodes corresponding to the TE and TM polarization components. The output of a photodiode that detects a TE polarization component and the output of a photodiode that detects a TM polarization component are input into a transimpedance amplifier in parallel and added together, and in this way, the sum of the outputs of the photodiodes corresponding to the TE and TM polarization components is acquired. However, in this case, the total parasitic capacitance of the two photodiodes connected in parallel with each other is 2 x Cpd with respect to the parasitic capacitance Cpd of a single photodiode. As a result, the RC time constant caused by the parasitic capacitance and the series resistance of the circuit increases, and the response speed of the photodiodes decreases.

Alternatively, the output of each photodiode can be separately input into a transimpedance amplifier and then the voltages of the transimpedance amplifiers can be added together using an analog circuit or a digital circuit. In this case, the response speed of the photodiodes will be high because the response speed corresponds to the parasitic capacitance Cpd of a single photodiode, but an amplifier or a DSP (digital signal processor) will be required to output the sum of the voltages. Therefore, the circuit size and power consumption will increase.

A device for detecting light may be configured so that the polarization components are detected by a single photodiode instead of the individual polarization components being detected by separate photodiodes. For example, as disclosed in the above-mentioned Patent Literature 1 (US Patent No. 10,488,593), a system may separate different polarization components Px and Py into two waveguides using a two-dimensional grating coupler, and then cause only light of a specific wavelength to be coupled into the next two waveguides via a Bragg reflector. The two waveguides used for the coupling are connected to a single photodiode. A single photodiode outputs the sum of the light intensities of the two polarization components as a photocurrent. In this way, an increase in parasitic capacitance, circuit size, or power consumption of the photodiodes can be avoided.

However, there are cases where reflected light from the Bragg reflector or light not absorbed by the photodiode returns to the optical communication system as return light. Return light can destabilize the operation of laser light sources used for communication.

In addition, a different configuration is disclosed in the following Literature A. Literature A: IEEE, Photonics Technology Letters, 31, 287 (2019)

The device described in the above Literature A couples different polarization components Px and Py into waveguides using a two-dimensional grating coupler, and then couples only light of a prescribed wavelength into the subsequent two waveguides using a ring filter provided on each waveguide. The two waveguides used in the coupling are connected to a two-dimensional grating coupler. The two-dimensional grating coupler emits the input light upwards from the substrate. A photodiode disposed above the two-dimensional grating coupler then converts the light emitted upwards from the substrate into an electrical signal. The device described in above Literature A can output the total light intensity of two polarizations using a single photodiode similarly to as in Patent Literature 1. However, return light from the grating coupler on the light-receiving element side may cause instability in the operation of a laser light source used for communication.

In addition, in the structure in Literature A, a photodiode needs to be provided above the two-dimensional grating coupler. In this case, photodiodes typically used in the field of optical communication technology, i.e., strained germanium epitaxially grown on a flat top silicon layer, cannot be used, and the manufacturing process becomes more complex. Furthermore, the sensitivity of the photodiode is reduced due to the structure in which light passes vertically through the epitaxial layer constituting the photodiode.

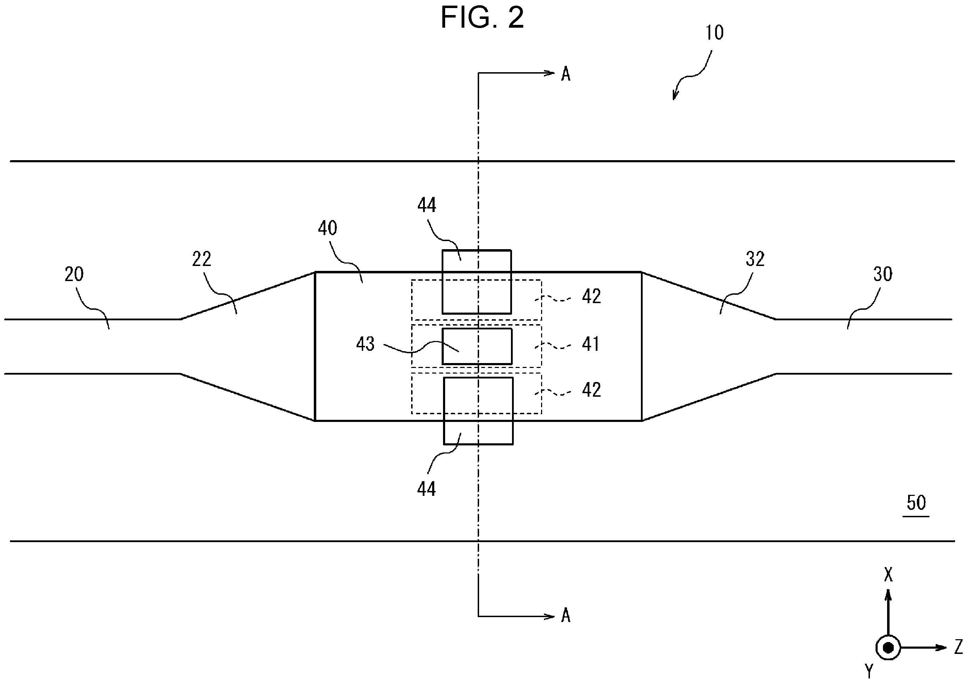

In an embodiment of the present disclosure, photodiodes 10 (see FIG. 2 etc.) are configured so that the sum of the light intensities of two polarizations, TE and TM, is output using a single photodiode. In addition, an optical receiver 1, which uses the photodiodes 10, is configured as a polarization-independent optical receiver. With the photodiodes 10 according to an embodiment of the present disclosure, return light can be reduced so as to realize a configuration where the parasitic capacitance of the photodiodes is kept small and an electrical circuit for adding together the outputs of two photodiodes corresponding to two polarization components is not required.

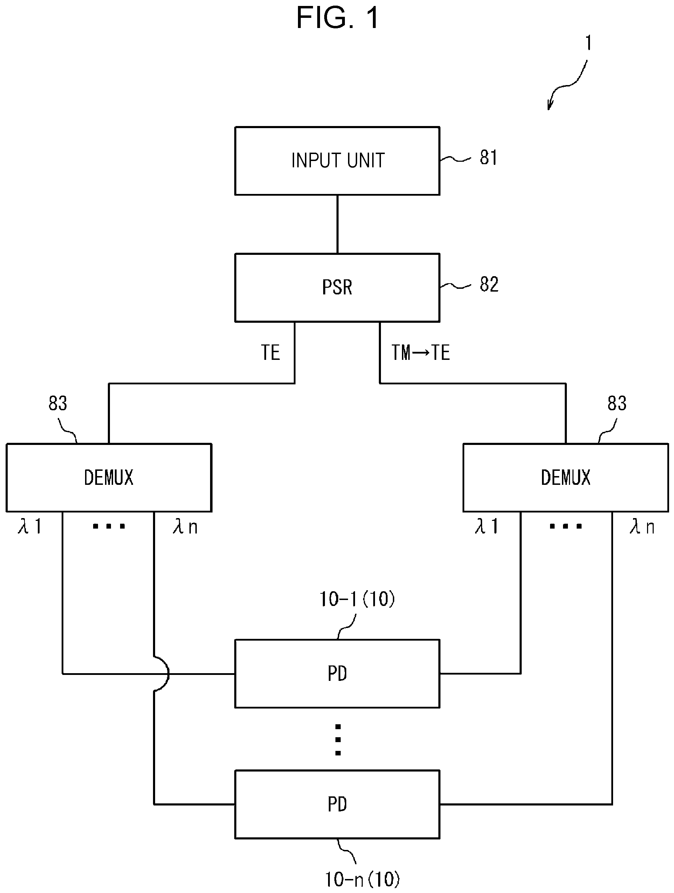

In an embodiment of the present disclosure, the optical receiver 1 (see FIG. 1 etc.) may be used in combination with a configuration for transmitting optical signals in an optical communication system. The configuration for transmitting optical signals may include a light source and a modulator.

The light source may include a semiconductor laser such as an LD (laser diode) or a VCSEL (vertical cavity surface emitting laser). The light source may include a device that emits electromagnetic waves of various wavelengths, not limited to visible light. The modulator modulates electromagnetic waves by changing the intensity of the electromagnetic waves. The modulator may pulse modulate the electromagnetic waves, for example.

The configuration for transmitting optical signals may further include a signal input unit. The signal input unit accepts input of signals from external devices, etc. The signal input unit may include a D/A converter, for example. The signal input unit outputs a signal to a modulator. The modulator modulates electromagnetic waves based on a signal acquired by the signal input unit.

Since the optical receiver 1 using the photodiodes 10 can reduce return light from the optical receiver 1 to the optical communication system, a polarization-independent optical receiver that operates at high speed and with low power consumption can be realized. In addition, since a photodiode can be formed on a flat silicon waveguide, strained germanium epitaxially grown on silicon can be used as a photodiode, and since the photodiode absorbs light propagating in a waveguide, light can be absorbed over a sufficiently long distance, and light-reception sensitivity can be increased.

### (Example Configuration of Optical Receiver 1)

An optical receiver 1 is configured to receive an optical signal. Hereafter, an example configuration of the optical receiver 1 according to an embodiment of the present disclosure will be described.

As illustrated in FIG. 1, the optical receiver 1 includes an input unit 81, a polarizing splitter rotator (PSR) 82, splitters (demultiplexers or DEMUXs) 83, and photodiodes (PDs) 10.

The input unit 81 is configured to accept input of an optical signal generated by a modulator etc. described above. The polarizing splitter rotator 82 separates a TE-mode optical signal and a TM-mode optical signal included in an input optical signal, and converts the TM-mode optical signal to a TE-mode optical signal. The splitters 83 separate the TE-mode optical signal separated by the polarizing splitter rotator 82 and the TE-mode optical signal converted from the TM-mode optical signal separated by the polarizing splitter rotator 82 into optical signals for each wavelength. In FIG. 1, the splitters 83 are each configured to separate the optical signal into n types of light with wavelengths represented by λ1 to λn.

The photodiodes 10 include photodiodes 10-1 to 10-n, which correspond to the respective wavelengths of light. Each photodiode 10 is connected to the splitter 83 that separates TE-mode optical signals by wavelength and the splitter 83 that separates TE-mode optical signals converted from the TM-mode optical signal by wavelength. **In** other words, each photodiode 10 includes a port that accepts input of light separated from a TE-mode optical signal and a port that accepts input of light separated from a TE-mode optical signal converted from a TM-mode optical signal. Each photodiode 10 is configured to detect both light of each wavelength separated from the TE-mode optical signal and light of each wavelength separated from the TE-mode optical signal converted from the TM-mode optical signal.

As described below, each photodiode 10 is configured so that an optical signal input to one port is unlikely to be transmitted to the other port. **In** other words, the optical signal has difficulty returning to the source of an optical signal. An optical signal returning to the source of an optical signal may result in instability in the light source or modulator, etc. at the source of the optical signal. Therefore, the light source or modulator etc. of the source of an optical signal can be protected by reducing return light. As a result, the reliability of the optical communication system can be improved.

### (Example Configuration of Photodiode 10)

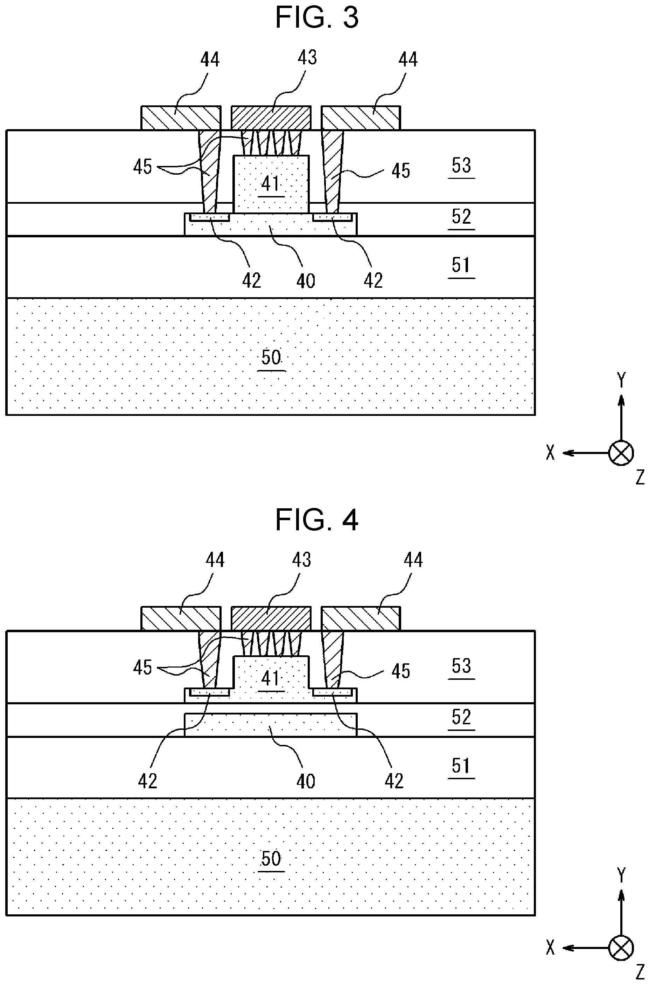

As illustrated in FIGs. 2 and 3, in an embodiment of the present disclosure, the photodiode 10 includes a light-receiving waveguide 40 and a light-receiving unit 41. The light-receiving waveguide 40 is connected to a first input waveguide 20 and a second input waveguide 30.

In the first input waveguide 20, the optical signal is assumed to travel in the positive Z-axis direction and be input to the light-receiving waveguide 40. The first input waveguide 20 may include a tapered portion 22 whose width in a direction intersecting the direction of travel of the optical signal (X-axis direction) changes in a continuous manner. The tapered portion 22 is configured so that the width of the first input waveguide 20 is equal to the width of the light-receiving waveguide 40 at the position where the first input waveguide 20 and the light-receiving waveguide 40 are connected to each other.

In the second input waveguide 30, the optical signal is assumed to travel in the negative Z-axis direction and be input to the light-receiving waveguide 40. The second input waveguide 30 may include a tapered portion 32 whose width in a direction intersecting the direction of travel of the optical signal (X-axis direction) changes in a continuous manner. The tapered portion 32 is configured so that the width of the second input waveguide 30 is equal to the width of the light-receiving waveguide 40 at the position where the second input waveguide 30 and the light-receiving waveguide 40 are connected to each other.

The light-receiving waveguide 40, the first input waveguide 20, and the second input waveguide 30 are disposed next to each other in the Z-axis direction on a substrate 50. The first input waveguide 20 and the second input waveguide 30 extend in the Z-axis direction. The light-receiving waveguide 40, the first input waveguide 20, and the second input waveguide 30 are disposed on a first insulating layer 51 on the substrate 50, and are surrounded by the first insulating layer 51 and a second insulating layer 52 in a cross-sectional view as illustrated in FIG. 3. The light-receiving waveguide 40, the first input waveguide 20, and the second input waveguide 30 function as the core of a waveguide. The first insulating layer 51 and the second insulating layer 52 function as the cladding of the waveguide.

The light-receiving unit 41 is positioned above the light-receiving waveguide 40. The light-receiving unit 41 functions as the core of the waveguide together with the light-receiving waveguide 40. In the range where the light-receiving unit 41 is positioned, the core has a multilayer structure consisting of the light-receiving unit 41 and the light-receiving waveguide 40 stacked on top of each other, and extends in the positive Y-axis direction on the whole. The core, in which the light-receiving unit 41 and the light-receiving waveguide 40 are stacked, is surrounded by the first insulating layer 51, the second insulating layer 52, and a third insulating layer 53. The third insulating layer 53 functions as the cladding of the waveguide together with the first insulating layer 51 and the second insulating layer 52.

Light that has propagated through the light-receiving waveguide 40 propagates to the light-receiving unit 41. The energy of the light that has propagated to the light-receiving unit 41 excites electrons in the light-receiving unit 41. As a result, the potential of the light-receiving unit 41 becomes lower than the potential of the light-receiving waveguide 40. In other words, a potential difference is generated between the light-receiving unit 41 and the light-receiving waveguide 40. The photodiode 10 outputs a photocurrent that flows due to the potential difference generated between the light-receiving unit 41 and the light-receiving waveguide 40 to an external device. The photocurrent corresponds to an electrical signal corresponding to the combined intensity of the optical signals respectively input to the first input waveguide 20 and the second input waveguide 30.

In this embodiment, the configuration of the photodiode 10 can be rephrased as follows. An optical signal input to the first input waveguide 20 is also referred to as a first optical signal. The direction in which the first optical signal is input (positive Z-axis direction) is also referred to as a first direction. An optical signal input to the second input waveguide 30 is also referred to as a second optical signal. The direction in which the second optical signal is input (negative Z-axis direction) is also referred to as a second direction. The light-receiving waveguide 40 is connected to the first input waveguide 20 and the second input waveguide 30. The light-receiving unit 41 outputs an electrical signal corresponding to the intensity of a signal obtained by combining the first optical signal and second optical signal input to the light-receiving waveguide 40. The light-receiving unit 41 is configured to reduce the intensity of an optical signal returning in the opposite direction from the first direction in which the first optical signal propagates in the first input waveguide 20, and the intensity of an optical signal returning in the opposite direction from the second direction in which the second optical signal propagates in the second input waveguide 30.

### <Material of Each Constituent Part of Photodiode 10>

The substrate 50 may include a semiconductor such as silicon, a conductor such as a metal, or an insulator such as glass or resin. In this embodiment, the substrate 50 is assumed to be composed of silicon (Si), but is not limited to this material and can be composed of various other materials.

The light-receiving waveguide 40, the light-receiving unit 41, the first input waveguide 20, and the second input waveguide 30, which function as the core, and the first insulating layer 51, the second insulating layer 52, and the third insulating layer 53, which function as the cladding, may include a dielectric. The light-receiving waveguide 40, the light-receiving unit 41, the first input waveguide 20, and the second input waveguide 30 are also referred to as dielectric waveguides. The materials of the core and cladding are selected so that the relative dielectric constant of the core is greater than the relative dielectric constant of the cladding. In other words, the materials of the core and cladding are selected so that the refractive index of the core for the light propagating therethrough is greater than the refractive index of the cladding. With this configuration, the light propagating through the core can be totally reflected at the boundary with the cladding. As a result, loss of an optical signal propagating through the core can be reduced.

In this embodiment, the materials of the light-receiving waveguide 40, the first input waveguide 20, and the second input waveguide 30, which function as the core, are silicon (Si). The material of the core is not limited to the above-described example and may be various other materials.

The material of the light-receiving unit 41, which functions as the core together with the light-receiving waveguide 40, is assumed to be germanium (Ge). The light-receiving unit 41 is configured as a pin diode having a germanium pin structure formed by epitaxial growth on the light-receiving waveguide 40. The configuration of the light-receiving unit 41 is not limited to the example described above.

In this embodiment, the materials of the first insulating layer 51, the second insulating layer 52, and the third insulating layer 53, which function as the cladding, are assumed to be quartz glass or a silicon oxide film (SiO₂). The material of the cladding is not limited to the above-described example and may be various other materials. The relative dielectric constant of silicon is approximately 12. The relative dielectric constant of germanium is approximately 16. The relative dielectric constant of quartz glass is approximately 2. Silicon can transmit electromagnetic waves having a near-infrared wavelength of approximately 1.2 µm to approximately 6 µm with low loss. When the light-receiving waveguide 40, the first input waveguide 20, and the second input waveguide 30 are composed of silicon, electromagnetic waves having wavelengths in the 1.3 µm band or 1.55 µm band used in optical communications can be transmitted therethrough with low loss.

The relative dielectric constants of the core and the cladding may be greater than the relative dielectric constant of air. By making the relative dielectric constants of the core and cladding greater than the relative dielectric constant of air, leakage of electromagnetic waves from the photodiode 10 can be reduced. As a result, loss caused by the radiation of electromagnetic waves from the photodiode 10 to the outside can be reduced.

The light-receiving waveguide 40, the first input waveguide 20, and the second input waveguide 30, which function as the core, may satisfy waveguide conditions for a single mode or waveguide conditions for multiple modes.

The photodiode 10 may further include an anode electrode 43 connected to the light-receiving unit 41 through a via electrode 45, and cathode electrodes 44 connected to electrode regions 42 of the light-receiving waveguide 40 through via electrodes 45. A photocurrent flowing between the light-receiving unit 41 and the light-receiving waveguide 40 is output to an external device by flowing between the anode electrode 43 and the cathode electrodes 44. The anode electrode 43, the cathode electrodes 44, and the via electrodes 45 may include metals or semiconductors. The electrode regions 42 may be formed as doped regions into which impurities have been injected into the silicon constituting the light-receiving waveguide 40 in order to lower the electrical resistance between the via electrodes 45 and the light-receiving waveguide 40.

### (Another Example Configuration of Photodiode 10)

As illustrated in FIG. 4, the photodiode 10 may be configured so that the second insulating layer 52 is sandwiched between the light-receiving unit 41 and the light-receiving waveguide 40. In this case, the electrode regions 42 are formed in the light-receiving unit 41. The second insulating layer 52 is configured to have a thickness less than or equal to a prescribed value so that light that has propagated through the light-receiving waveguide 40 can propagate through the second insulating layer 52 to the light-receiving unit 41. The presence of the thin second insulating layer 52 on top of the light-receiving waveguide 40 allows the light-receiving waveguide 40 to be protected when forming the light-receiving unit 41.

### <Comparative Example>

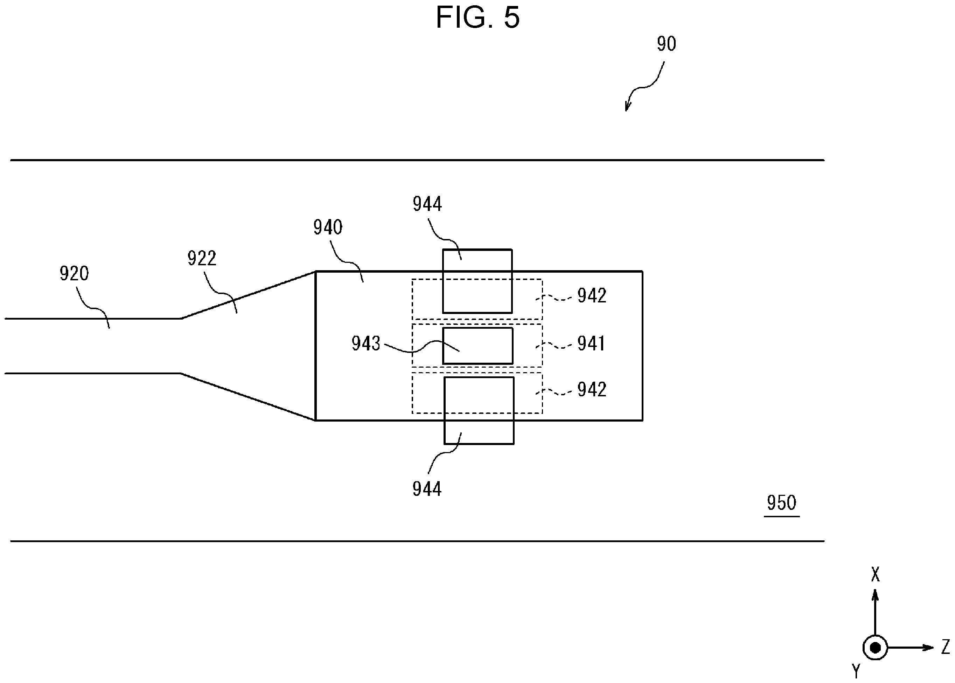

In a comparative example, a photodiode 90 includes a light-receiving waveguide 940, a light-receiving unit 941, electrode regions 942, a cathode electrode 943, anode electrodes 944, and a substrate 950, as illustrated in FIG. 5. The light-receiving waveguide 940 is connected to an input waveguide 920.

In the input waveguide 920, an optical signal travels in the positive Z-axis direction and is input to the light-receiving waveguide 940. The input waveguide 920 may include a tapered portion 922 whose width in a direction intersecting the direction of travel of the optical signal (X-axis direction) changes in a continuous manner. The light-receiving waveguide 940 and the input waveguide 920 are disposed side by side in the Z-axis direction on the substrate 950. The input waveguide 920 extends in the Z-axis direction. The light-receiving unit 941 is positioned above the light-receiving waveguide 940.

Light that has propagated through the light-receiving waveguide 940 propagates to the light-receiving unit 941. The energy of the light that has propagated to the light-receiving unit 941 excites electrons in the light-receiving unit 941. As a result, the potential of the light-receiving unit 941 becomes lower than the potential of the light-receiving waveguide 940. In other words, a potential difference is generated between the light-receiving unit 941 and the light-receiving waveguide 940. The photodiode 90 outputs a photocurrent that flows between the cathode electrode 943 and the anode electrodes 944 to an external device due to the potential difference generated between the light-receiving unit 941 and the light-receiving waveguide 940. The photocurrent corresponds to an electrical signal corresponding to the intensity of the single optical signal input to the single input waveguide 920.

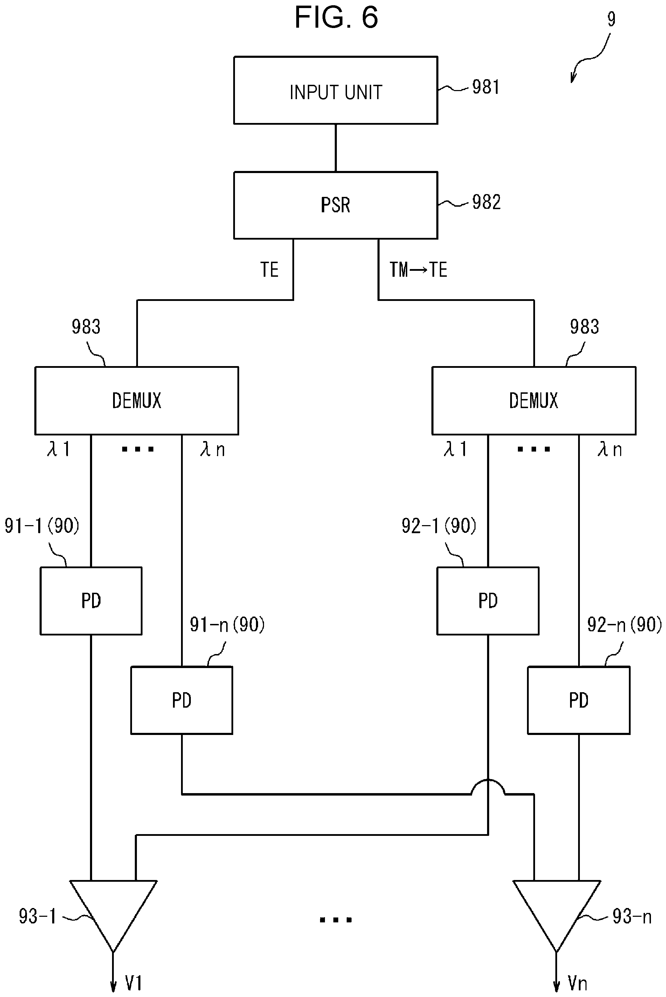

In the comparative example, an optical receiver 9 includes an input unit 981, a polarizing splitter rotator (PSR) 982, splitters (DEMUXs) 983, photodiodes (PDs) 90, and transimpedance amplifiers (TIA) 93-1 to n, as illustrated in FIG. 6.

The input unit 981 accepts input of an optical signal. The polarizing splitter rotator 982 separates a TE-mode optical signal and a TM-mode optical signal included in an input optical signal, and converts the TM-mode optical signal to a TE-mode optical signal. The splitters 983 separate the TE-mode optical signal separated by the polarizing splitter rotator 982 and the TE-mode optical signal converted from the TM-mode optical signal separated by the polarizing splitter rotator 982 into optical signals for each wavelength. The splitters 983 are each configured to separate the optical signal into n types of light with wavelengths represented by λ1 to λn.

The photodiodes 90 include photodiodes 91-1 to n connected to the splitter 983 that separates TE-mode optical signal by wavelength. The photodiodes 90 further include photodiodes 92-1 to n connected to the splitter 983 that separates the optical signal converted from TM mode to TE mode by the polarizing splitter rotator 82 for each wavelength. The transimpedance amplifier 93-1 outputs an electrical signal V1 that is the sum of an electrical signal output from the photodiode 91-1 and an electrical signal output from the photodiode 92-1. The transimpedance amplifier 93-n outputs an electrical signal Vn that is the sum of an electrical signal output from the photodiode 91-n and an electrical signal output from the photodiode 92-n. In other words, in the optical receiver 9 of the comparative example, the photodiodes 90 can only output an electrical signal corresponding to the intensity of a single optical signal, and therefore the transimpedance amplifiers 93-1 to n are required to add the electrical signals output from the photodiodes 91-1 to n and the photodiodes 92-1 to n.

Here, the electrical signals of two photodiodes 90 are input in parallel to a single transimpedance amplifier 93, and therefore the parasitic capacitance of the photodiodes 90 is doubled. The RC time constant is increased due to the increase in the parasitic capacitance. The response of the photodiodes 90 slows down due to the increase in the RC time constant. In addition, if an electrical signal from one photodiode 90 is input to a single transimpedance amplifier 93 and the outputs of the transimpedance amplifiers 93 are added in separate analog or digital circuits, the circuit size will increase and power consumption will increase.

On the other hand, in this embodiment, the photodiodes 10 are each configured to output an electrical signal corresponding to the combined intensity of two optical signals. In this embodiment, the optical receiver 1 that uses the photodiodes 10 does not require a configuration in which two photodiodes 10 are connected in parallel, and therefore the response speed of the optical receiver 1 can be maintained. In addition, in this embodiment, the optical receiver 1 that uses the photodiode 10 does not require a circuit for adding together two electrical signals. As a result, an increase in circuit size or power consumption can be avoided.

As another comparative example, let us suppose that a photodiode that outputs an electrical signal corresponding to the intensities of two optical signals is configured so that the two optical signals simply enter a single light-receiving unit. In this configuration, the optical signals that enter the light-receiving unit may be reflected and become return light. In addition, there are cases where an optical signal input from one of two ports that accept input of two optical signals passes through the light-receiving unit and propagates to the other port as return light. When an optical signal that has become return light returns to the light source or modulator, the operation of the light source or modulator, etc. may become unstable.

On the other hand, in this embodiment, the photodiode 10 is configured to reduce optical signals returning to the first input waveguide 20 and the second input waveguide 30. In other words, in this embodiment, the photodiode 10 is configured to reduce return light. In this embodiment, the optical receiver 1 using the photodiodes 10 can reduce return light, and therefore operation of the light source or modulator, etc. can be protected. As a result, the reliability of the optical communication system can be improved.

### (Example Configuration of Photodiode 10 That Reduces Return Light)

As mentioned above, in this embodiment, the photodiode 10 is configured so that the optical signal input to one port is unlikely to be transmitted to the other port. In other words, in this embodiment, the photodiode 10 is configured to reduce return light. Hereafter, examples of configurations that reduce return light, including straight-type, intersection-type, and multi-mode interference (MMI) type configurations, are described.

### <Straight Type>

As illustrated in FIG. 2, the straight-type photodiode 10 is configured so that the first input waveguide 20 and the second input waveguide 30 are positioned along a single straight line (the Z-axis). In other words, the first direction in which the first optical signal input from the first input waveguide 20 propagates and the second direction in which the second optical signal input from the second input waveguide 30 propagates may be approximately parallel.

The optical signals propagating from the first input waveguide 20 and the second input waveguide 30 propagate to the light-receiving unit 41 and are absorbed by the light-receiving unit 41. Here, part of the optical signal propagating in the positive Z-axis direction from the first input waveguide 20 can be reflected at the end portion, on the negative Z-axis direction side, of the light-receiving unit 41 and become return light for the first input waveguide 20. Here, part of the optical signal propagating in the negative Z-axis direction from the second input waveguide 30 can be reflected at the end portion, on the positive Z-axis direction side, of the light-receiving unit 41 and become return light for the second input waveguide 30.

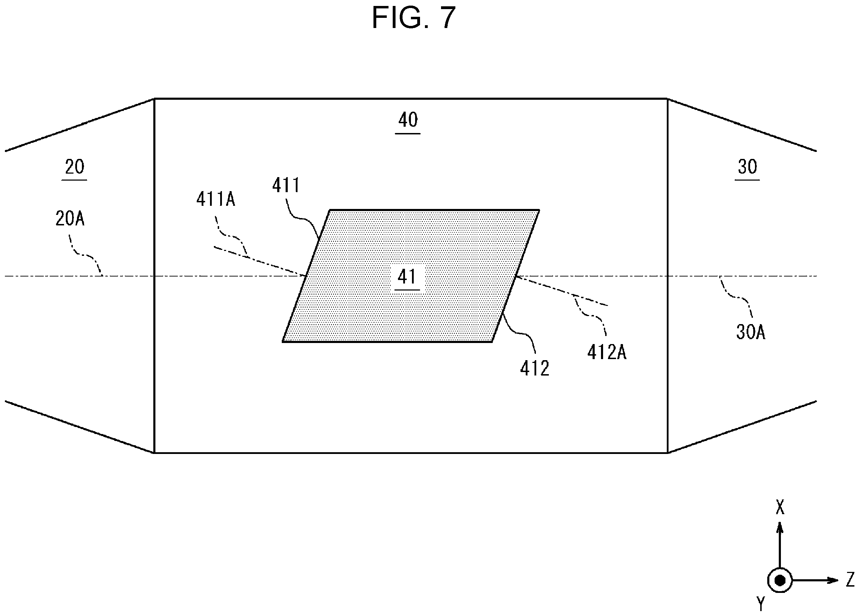

In this embodiment, the light-receiving unit 41 of the photodiode 10 may be configured so that a normal 411A of an end surface 411 thereof on the side connected to the first input waveguide 20 is inclined with respect to an optical axis 20A of the first input waveguide 20, as illustrated in FIG. 7. In addition, the light-receiving unit 41 may be configured so that a normal 412A of an end surface 412 thereof on the side connected to the second input waveguide 30 is inclined with respect to an optical axis 30A of the second input waveguide 30. As a result of the end surfaces 411 and 412 of the light-receiving unit 41 being inclined with respect to the optical axes 20A and 30A, the optical signals reflected at the end surfaces 411 and 412 propagate in directions that are offset from the optical axes 20A and 30A, and the optical signals are unlikely to return to the first input waveguide 20 and the second input waveguide 30. In addition, when the normal 411A is inclined with respect to the optical axis 20A, the direction of travel of the light incident on the light-receiving unit 41 is inclined with respect to the optical axis 20A due to refraction of the light. In this case, the proportion of light, out of light that passes through the light-receiving unit 41 without being absorbed by the light-receiving unit 41, that enters the opposing second input waveguide 30 as return light can be reduced.

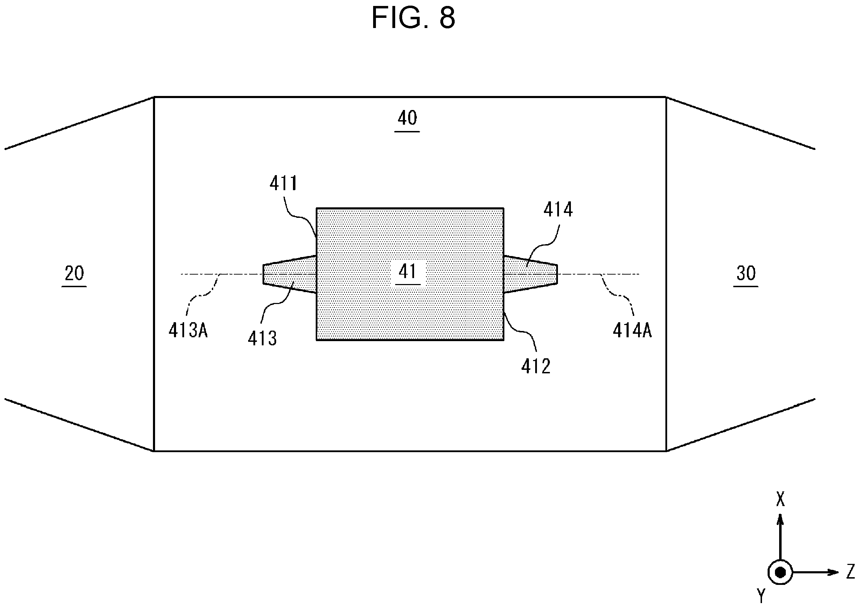

In addition, in this embodiment, the light-receiving unit 41 of the photodiode 10 may include a protrusion 413 on the end surface 411, as illustrated in FIG. 8. In addition, the light-receiving unit 41 may include the protrusion 414 on the end surface 412. The protrusions 413 and 414 may have a reverse taper shape in which the width in the X-axis direction increases as one moves in the direction in which the optical signal propagates (the width in the X-axis direction decreases as one moves in the direction away from the light-receiving unit 41) in plan view (when viewed in the Y-axis direction). Due to the end surfaces 411 and 412 including the protrusions 413 and 414, the optical signals that propagate so as to be input to the light-receiving unit 41 are unlikely to be reflected in the opposite direction from the input direction at the parts of the protrusions 413 and 414 where the width in the X-axis direction is narrow. As a result, the optical signals are unlikely to return to the first input waveguide 20 and the second input waveguide 30.

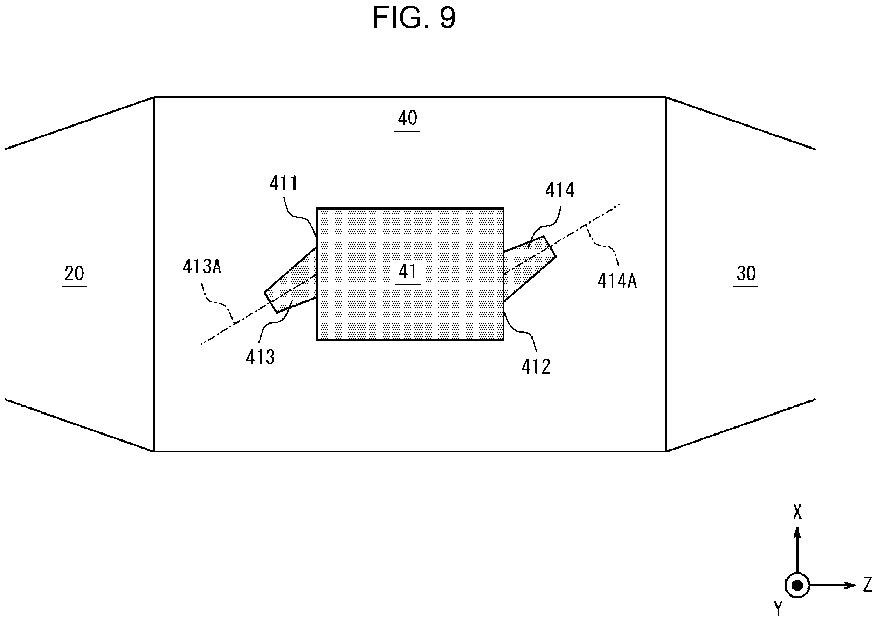

In the example in FIG. 8, an axis 413A of the protrusion 413 is aligned with the optical axis 20A of the first input waveguide 20 (Z-axis direction). In addition, an axis 414A of the protrusion 414 is aligned with the direction of the optical axis 30A of the second input waveguide 30 (Z-axis direction). As illustrated in FIG. 9, the axis 413A of the protrusion 413 may be inclined with respect to the direction of the optical axis 20A (Z-axis direction). In addition, the axis 414A of the protrusion 414 may be inclined with respect to the direction of the optical axis 30A (Z-axis direction). With this configuration, the optical signals reflected at the tips of the protrusions 413 and 414 propagate in directions offset from the optical axes 20A and 30A, and are unlikely to return to the first input waveguide 20 and the second input waveguide 30.

As described above, the shapes of the end surfaces 411 and 412 of the light-receiving unit 41 of the straight-type photodiode 10 are set so as to reduce the amount of return light generated by reflection at the end surfaces 411 and 412.

### <Intersection Type>

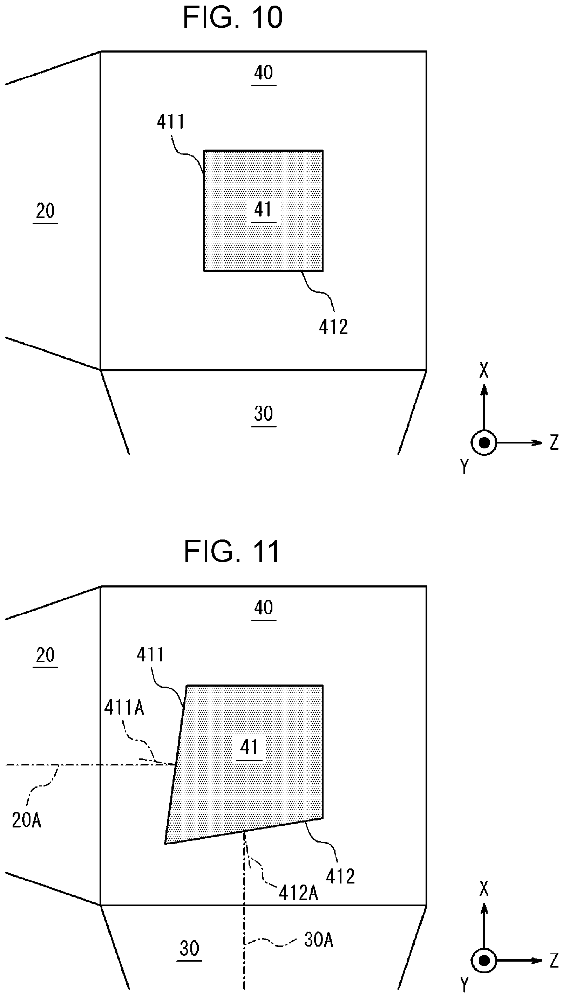

As illustrated in FIG. 10, an intersection-type photodiode 10 is configured so that the first input waveguide 20 and the second input waveguide 30 intersect each other. In other words, the angle between the first direction in which the first optical signal input from the first input waveguide 20 propagates and the second direction in which the second optical signal input from the second input waveguide 30 propagates may lie within a prescribed range including 90 degrees.

The optical signals propagating from the first input waveguide 20 and the second input waveguide 30 propagate to the light-receiving unit 41 and are absorbed by the light-receiving unit 41. Here, part of the optical signal propagating in the positive Z-axis direction from the first input waveguide 20 passes through the light-receiving unit 41 (without being absorbed by the light-receiving unit 41) and continues to propagate in the positive Z-axis direction. However, because the second input waveguide 30 intersects the first input waveguide 20, the optical signal propagating in the positive Z-axis direction from the first input waveguide 20 is unlikely to propagate into the second input waveguide 30 even if the optical signal passes through the light-receiving unit 41. In addition, part of the optical signal propagating in the positive X-axis direction from the second input waveguide 30 passes through the light-receiving unit 41 (without being absorbed by the light-receiving unit 41) and continues to propagate in the positive X-axis direction. However, because the first input waveguide 20 intersects the second input waveguide 30, the optical signal propagating in the positive X-axis direction from the second input waveguide 30 is unlikely to propagate into the first input waveguide 20 even if the optical signal passes through the light-receiving unit 41. As mentioned above, when the first input waveguide 20 and the second input waveguide 30 intersect each other, the optical signal input from one waveguide is unlikely to propagate to the other waveguide and become return light even if the optical signal passes through the light-receiving unit 41.

In the intersection-type photodiode 10 illustrated in FIG. 10, the light-receiving unit 41 may be configured so that the normal 411A of the end surface 411 thereof on the side connected to the first input waveguide 20 is inclined with respect to the optical axis 20A of the first input waveguide 20 as illustrated in FIG. 11. In addition, the light-receiving unit 41 may be configured so that the normal 412A of the end surface 412 thereof on the side connected to the second input waveguide 30 is inclined with respect to the optical axis 30A of the second input waveguide 30.

As a result of the end surfaces 411 and 412 of the light-receiving unit 41 being inclined with respect to the optical axes 20A and 30A, the optical signals reflected at the end surfaces 411 and 412 propagate in directions that are offset from the optical axes 20A and 30A, and the optical signals are unlikely to return to the first input waveguide 20 and the second input waveguide 30. Thus, return light caused by reflection of optical signals at the end surfaces 411 and 412 can be reduced.

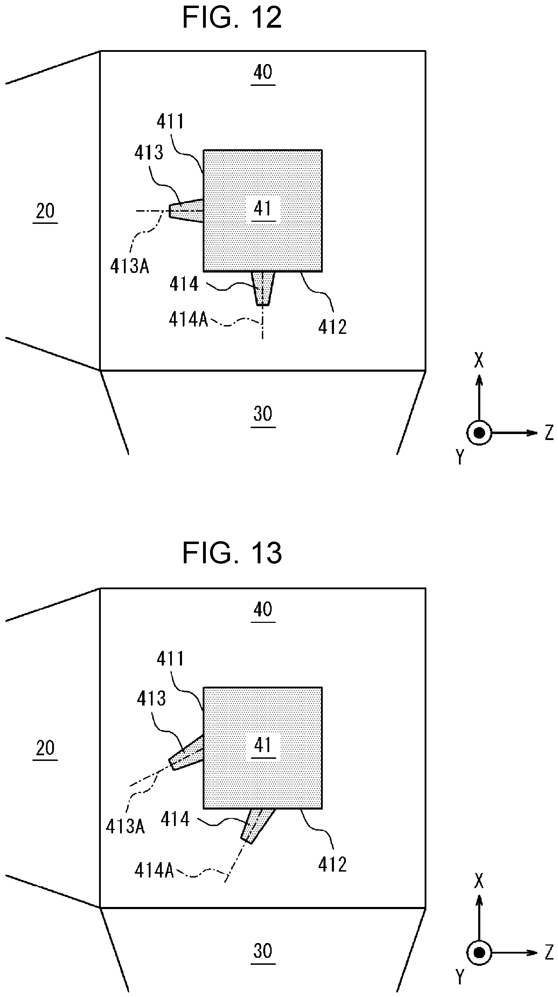

In addition, in the intersection-type photodiode 10 illustrated in FIG. 10, the light-receiving unit 41 may include the protrusion 413 on the end surface 411, as illustrated in FIG. 12. In addition, the light-receiving unit 41 may include the protrusion 414 on the end surface 412. The protrusions 413 and 414 may have a reverse taper shape in which the width in the X-axis direction increases as one moves in the direction in which the optical signal propagates (the width in the X-axis direction decreases as one moves in the direction away from the light-receiving unit 41) in plan view (when viewed in the Y-axis direction). Due to the end surfaces 411 and 412 including the protrusions 413 and 414, the optical signals that propagate so as to be input to the light-receiving unit 41 are unlikely to be reflected in the opposite direction from the input direction at the parts of the protrusions 413 and 414 where the width in the X-axis direction is narrow. As a result, the optical signals are unlikely to return to the first input waveguide 20 and the second input waveguide 30.

In the example in FIG. 12, the axis 413A of the protrusion 413 is aligned with the direction of the optical axis 20A of the first input waveguide 20 (Z-axis direction). In addition, the axis 414A of the protrusion 414 is aligned with the direction of the optical axis 30A of the second input waveguide 30 (Z-axis direction). As illustrated in FIG. 13, the axis 413A of the protrusion 413 may be inclined with respect to the direction of the optical axis 20A (Z-axis direction). In addition, the axis 414A of the protrusion 414 may be inclined with respect to the direction of the optical axis 30A (Z-axis direction). With this configuration, the optical signals reflected at the tips of the protrusions 413 and 414 propagate in directions offset from the optical axes 20A and 30A, and are unlikely to return to the first input waveguide 20 and the second input waveguide 30.

As described above, the intersection-type photodiode 10 can reduce return light caused by optical signals passing through the light-receiving unit 41. In addition, the shapes of the end surfaces 411 and 412 may be set so as to reduce return light generated by reflection at the end surfaces 411 and 412 of the light-receiving unit 41.

The configuration of the intersection-type photodiode 10 can be rephrased as follows. The end surface 411 is also referred to as a first surface. The end surface 412 is also referred to as a second surface. The light-receiving unit 41 has the first surface positioned on the first direction side and the second surface positioned on the second direction side. At least part of the first surface may include a surface having a normal direction that is not parallel to the first direction. In addition, at least part of second surface may include a surface having a normal direction that is not parallel to the second direction.

### <Multimode Interference Type (MMI Type)>

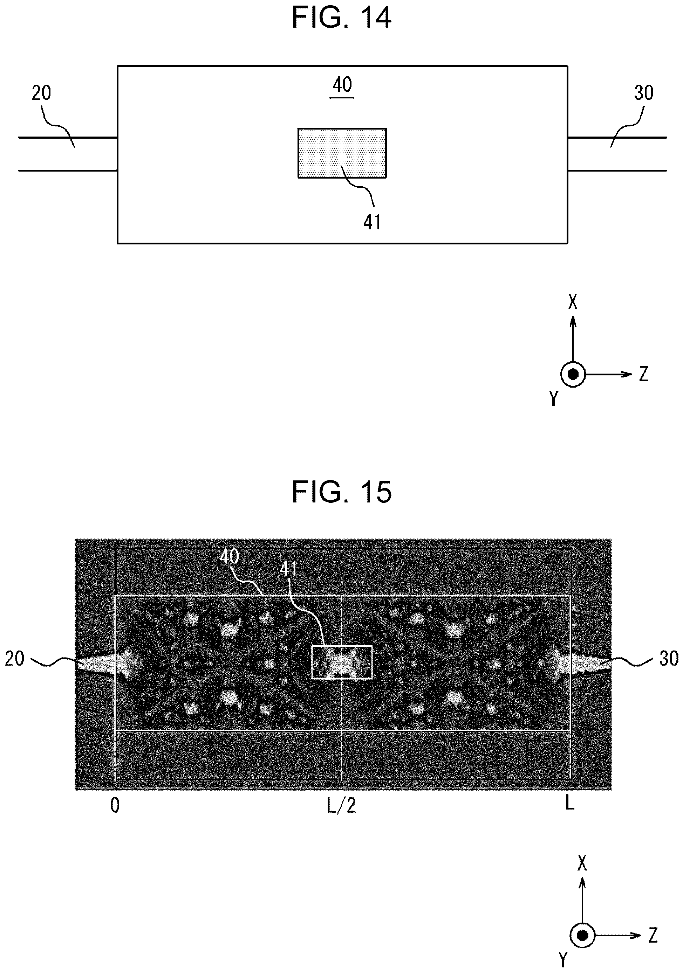

As illustrated in FIG. 14, the MMI-type photodiode 10 is configured so that an optical signal that has propagated from the first input waveguide 20 to the light-receiving waveguide 40 and an optical signal that has propagated from the second input waveguide 30 to the light-receiving waveguide 40 cause multimode interference in the light-receiving waveguide 40. In other words, the MMI-type photodiode 10 is configured so that the light-receiving waveguide 40 functions as a multimode waveguide and operates as a multimode interference system.

Specifically, in the MMI-type photodiode 10, the first input waveguide 20 and the light-receiving waveguide 40 are connected in a discontinuous manner. In addition, the second input waveguide 30 and the light-receiving waveguide 40 are connected in a discontinuous manner. The state in which the first input waveguide 20 and the light-receiving waveguide 40 are connected in a discontinuous manner can correspond to a state in which the width of the first input waveguide 20 and the width of the light-receiving waveguide 40 are different from each other at a connection portion between the first input waveguide 20 and the light-receiving waveguide 40. In other words, the state in which the first input waveguide 20 and the light-receiving waveguide 40 are connected in a discontinuous manner corresponds to a state in which the first input waveguide 20, which does not include the tapered portion 22 (see FIG. 2), is connected to the light-receiving waveguide 40.

The state in which the first input waveguide 20 and the light-receiving waveguide 40 are connected in a discontinuous manner may correspond to a state in which the rate of change of the width of the light-receiving waveguide 40 relative to the width of the first input waveguide 20 when moving along the first direction is greater than or equal to a prescribed value. The rate of change is calculated as half the amount of change of the width of the waveguide when moving a unit distance along the first direction. The reason for setting the rate of change to half the amount of change of the width of the waveguide is that the shape of the ends of the waveguide are considered to be line-symmetrical about the first direction. The prescribed value may be set to 1, for example. When the prescribed value is 1, the direction in which a line representing an end of the light-receiving waveguide 40 extends forms a 45-degree angle with respect to the first direction. The state in which the second input waveguide 30 and the light-receiving waveguide 40 are connected in a discontinuous manner may correspond to a state in which the rate of change of the width of the light-receiving waveguide 40 relative to the width of the second input waveguide 30 when advancing along the second direction is greater than or equal to a prescribed value. In other words, this state may correspond to a state in which the rate of change of the width of the light-receiving waveguide 40 relative to the width of the first input waveguide 20 and the second input waveguide 30 when moving along the direction of travel of the optical signal is greater than or equal to a prescribed value.

In the MMI-type photodiode 10, the light-receiving unit 41 is disposed at the light-focusing position of the multimode waveguide. As a result, an optical signal can be absorbed with high efficiency in the light-receiving unit 41.

In the case of a MMI-type photodiode 10, the intensity of an optical signal that has propagated from the first input waveguide 20 to the light-receiving waveguide 40 can be distributed as illustrated in FIG. 15 in the light-receiving waveguide 40. In FIG. 15, the first input waveguide 20 and the light-receiving waveguide 40 are connected at the position Z = 0. The second input waveguide 30 and the light-receiving waveguide 40 are connected at the position Z = L. The light-receiving unit 41 is disposed at the position Z = L/2, which is at the center of the light-receiving waveguide 40.

In FIG. 15, the parts where the brightness is high (parts close to white) indicate parts where the intensity of the optical signal is high. The position where the intensity of the optical signal is high is the position where the light is focused in the multimode waveguide. In FIG. 15, the light-receiving unit 41 is disposed at the light-focusing position.

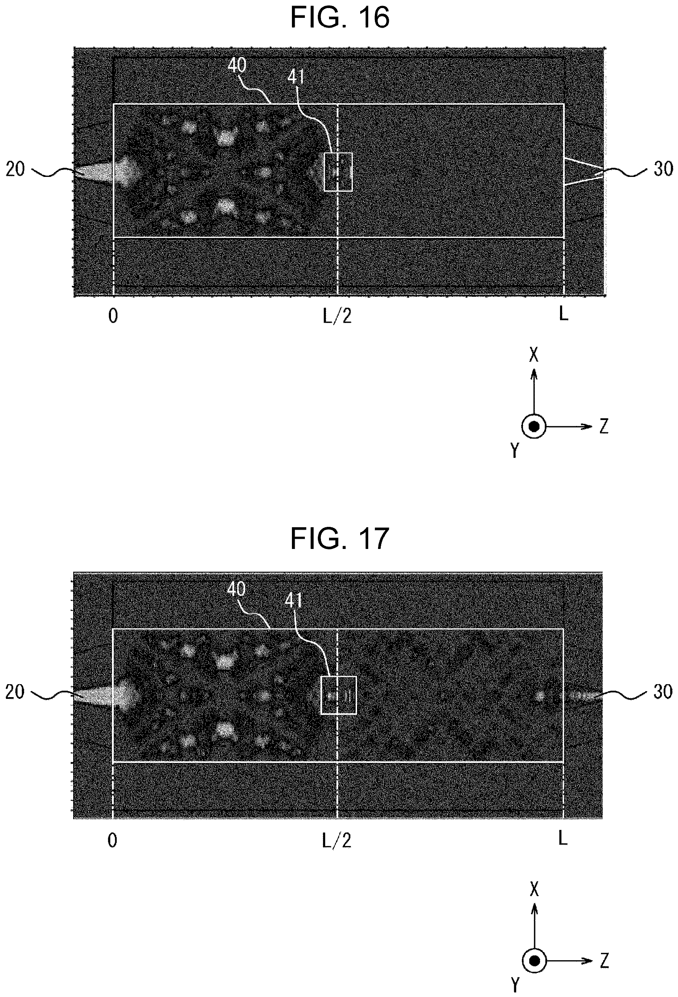

The optical signal intensity distribution illustrated in FIG. 15 represents the optical signal intensity distribution when the light-receiving unit 41 is not disposed in the light-receiving waveguide 40. When the light-receiving unit 41 is not disposed, the optical signal is refocused and the intensity of the optical signal is high even at the position Z = L. If the light-receiving unit 41 has a refractive index close to that of the light-receiving waveguide 40 and is disposed in the light-receiving waveguide 40, as illustrated in FIG. 16, the intensity of the optical signal will be low in the region where Z > L/2. In addition, the intensity of the optical signal at the position of the second input waveguide 30 (position Z = L) is greatly reduced by changing the MMI focal point to a position Z < L. The intensity of the optical signal at the position Z = L is greatly reduced, and the optical signal that passes through the second input waveguide 30 and becomes return light, out of the optical signal that has propagated from the first input waveguide 20, is greatly reduced. In the configuration illustrated in FIG. 16, the intensity of the return light to the second input waveguide 30 is at least -20 dB relative to the intensity of the optical signal that has propagated from the first input waveguide 20 when there is no absorption of light in the light-receiving unit 41. When the absorption of light by the germanium constituting the light-receiving unit 41 is taken into account, the intensity of the return light to the second input waveguide 30 is at least -30 dB relative to the intensity of the optical signal that has propagated from the first input waveguide 20.

If the length of the light-receiving unit 41 in the Z-axis direction is made greater than that in the configuration illustrated in FIG. 16, there is a length where light that has passed through the light-receiving unit 41 is once again confined in the light-receiving waveguide 40. As a result, as illustrated in FIG. 17, the intensity of the optical signal in the region where Z > L/2 is higher than the intensity illustrated in FIG. 16. In addition, as the focal point of the MMI approaches the position Z = L, the intensity of the optical signal at the position Z = L becomes higher than the intensity illustrated in FIG. 16. From the above description, the dimensions of the light-receiving unit 41 in the MMI-type photodiode 10 affect the return light caused by transmission through the light-receiving unit 41. In other words, when the dimension of the light-receiving unit 41 in the Z-axis direction is a suitable length, the component of the light that passes through the light-receiving unit 41 in the Z-axis direction and exits vertically (Y-axis direction) from the light-receiving waveguide 40 increases. As a result, the intensity of light confined in the light-receiving waveguide 40 decreases in the region where Z > L/2. On the other hand, if the dimension of the light-receiving unit 41 in the Z-axis direction is a different from a suitable length, the dimension could be a length where light is perfectly coupled in the light-receiving waveguide 40 at the end of the light-receiving unit 41. In this case, as illustrated in FIG. 17, the intensity of light propagating inside the light-receiving waveguide 40 is higher in the region where Z > L/2. As a phenomenon, light interference similar to that in MMI occurs in the Y-axis direction in the region where the light-receiving unit 41 is present. As a result of the light interference, depending on the length of the light-receiving unit 41, the light intensity at the end of the light-receiving unit 41 on the transmission side may increase, as illustrated in FIG. 17, or decrease, as illustrated in FIG. 16, at the height of the light-receiving waveguide 40.

Comparing FIGs. 16 and 17, the intensity of the optical signal transmitted to the second input waveguide 30 is lower when the dimension of the light-receiving unit 41 in the Z-axis direction is smaller. From this, we can see that both an increase in the absorption rate in the light-receiving unit 41 and a decrease in the size of the light-receiving unit 41 can be achieved in the MMI-type photodiode 10.

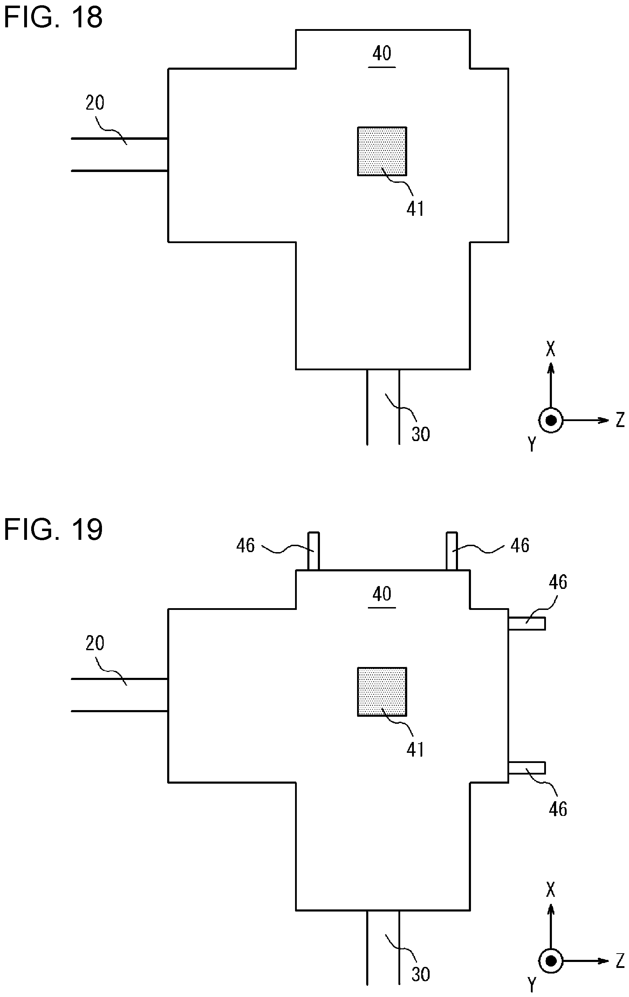

As illustrated in FIG. 18, in the MMI-type photodiode 10 as well, the first input waveguide 20 and the second input waveguide 30 may intersect each other. When the first input waveguide 20 and the second input waveguide 30 intersect each other, an optical signal that has passed through the light-receiving unit 41, out of the optical signal that has propagated from the first input waveguide 20, propagates in the part of the light-receiving waveguide 40 not connected to the second input waveguide 30. As a result, even if the optical signal that has propagated from the first input waveguide 20 passes through the light-receiving unit 41, return light propagating to the second input waveguide 30 can be reduced.

As illustrated in FIG. 19, the light-receiving waveguide 40 may include a terminating waveguide 46 at an end in the propagation direction of the optical signal from the first input waveguide 20 and at an end in the propagation direction of the optical signal from the second input waveguide 30. The terminating waveguide 46 disposed at the end in the propagation direction of the optical signal from the first input waveguide 20 (opposite side from the first input waveguide 20 along the first direction in the light-receiving waveguide 40) is also referred to as a first terminating waveguide. The terminating waveguide 46 disposed at the end in the propagation direction of the optical signal from the second input waveguide 30 (opposite side from the second input waveguide 30 along the second direction in the light-receiving waveguide 40) is also referred to as a second terminating waveguide. The light-receiving waveguide 40 may include at least one of the first terminating waveguide or the second terminating waveguide.

When the light-receiving waveguide 40 includes the terminating waveguides 46, the dimensions of the light-receiving waveguide 40 may be set so that the parts where the terminating waveguides 46 are connected become light-focusing positions. The terminating waveguides 46 may include antennas that radiate electromagnetic waves. The terminating waveguides 46 may include absorption members that absorb electromagnetic waves. The terminating waveguides 46 may be installed at the ends of the light-receiving waveguide 40 in the width direction, as illustrated in FIG. 19. The terminating waveguides 46 may be installed across the entirety of the width direction of the light-receiving waveguide 40, or may be installed at any positions in the width direction of the light-receiving waveguide 40.

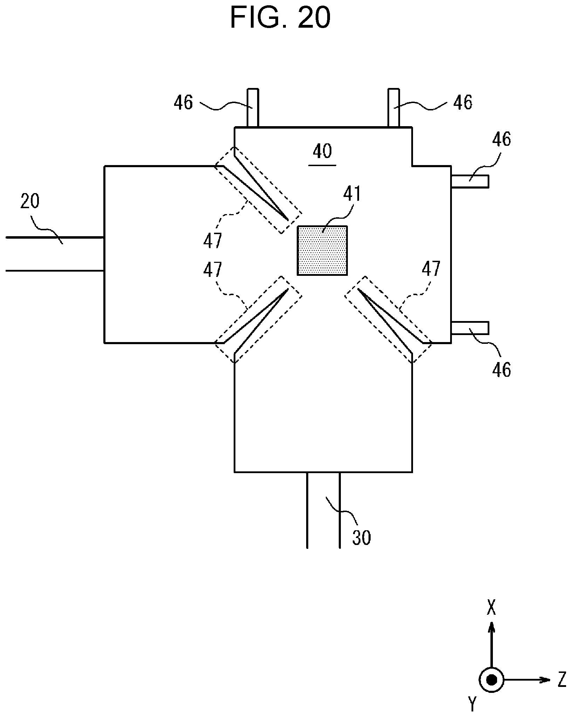

As illustrated in FIG. 20, the light-receiving waveguide 40 may include cutouts 47 between the part where the first input waveguide 20 is connected and the part where the light-receiving unit 41 is installed, and between the part where the second input waveguide 30 is connected and the part where the light-receiving unit 41 is installed. The cutouts 47 are configured to impede the propagation of optical signals other than those that are focused at the light-receiving unit 41, from among optical signals that have propagated from the first input waveguide 20 and the second input waveguide 30. In this way, the intensity of optical signals transmitted through the light-receiving unit 41 can be reduced.

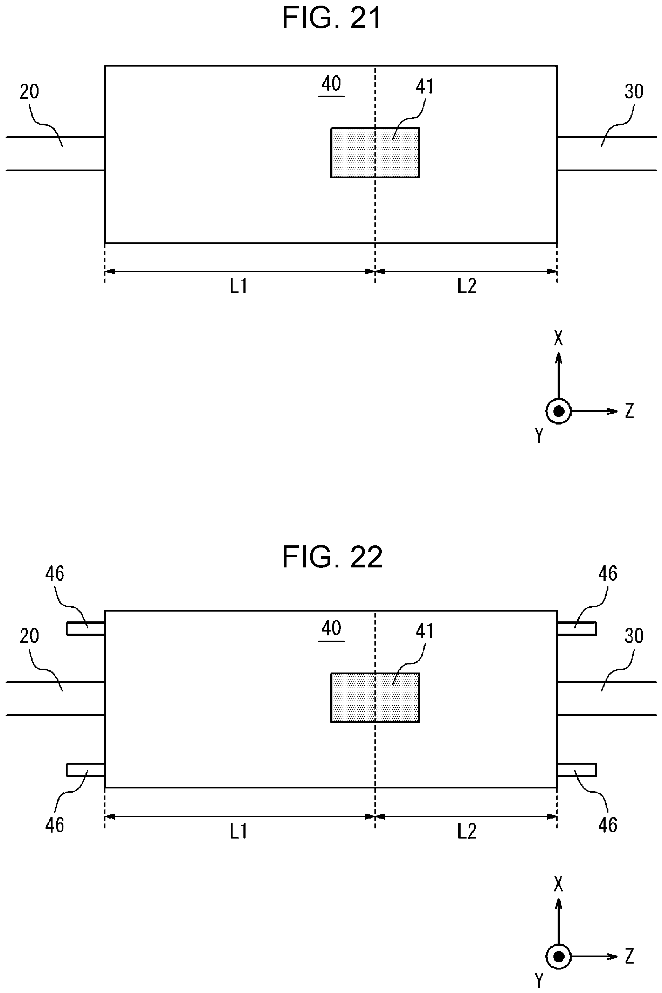

The MMI-type photodiode 10 may be configured such that the position of the light-receiving unit 41 in the light-receiving waveguide 40 is offset from the center of the light-receiving waveguide 40 in the direction of travel (Z-axis direction) of an optical signal. As illustrated in FIG. 21, a distance L1 from the position of the connection between the first input waveguide 20 and the light-receiving waveguide 40 to the position of the light-receiving unit 41 may differ from a distance L2 from the position of the connection between the second input waveguide 30 and the light-receiving waveguide 40 to the position of the light-receiving unit 41. L1 and L2 may be set to match the period with which the focus position of the optical signal appears in the Z-axis direction.

When L1 and L2 are different from each other, the polarization mode of an optical signal propagating from the first input waveguide 20 and the polarization mode of an optical signal propagating from the second input waveguide 30 may differ from each other. Specifically, the optical signal propagating from the first input waveguide 20 may be a TE-mode optical signal, and the optical signal propagating from the second input waveguide 30 may be a TM-mode optical signal. In this case, L1 and L2 may be set in accordance with the focus position of the optical signal propagating in each polarization mode.

When the polarization mode of the optical signal propagating from the first input waveguide 20 is different from the polarization mode of the optical signal propagating from the second input waveguide 30, the light-receiving waveguide 40 can be configured so that the optical signal propagating from the first input waveguide 20 is focused at a position close to an end in the width direction of the end portion on the side where the second input waveguide 30 is connected. In this way, optical signals that propagate to the second input waveguide 30 as return light, from among optical signals that have propagated from the first input waveguide 20, can be reduced.

As illustrated in FIG. 22, the light-receiving waveguide 40 may include the terminating waveguide 46 at the end in the propagation direction of the optical signal from the first input waveguide 20 (the end portion on side where the second input waveguide 30 is connected). The terminating waveguide 46 may be connected at a position where the optical signal that has propagated from the first input waveguide 20 is focused at the end portion on the side where the second input waveguide 30 is connected. In addition, the light-receiving waveguide 40 may include the terminating waveguide 46 at the end in the propagation direction of the optical signal from the second input waveguide 30 (the end portion on side where the first input waveguide 20 is connected). The terminating waveguide 46 may be connected at a position where the optical signal that has propagated from the second input waveguide 30 is focused at the end portion on the side where the first input waveguide 20 is connected.

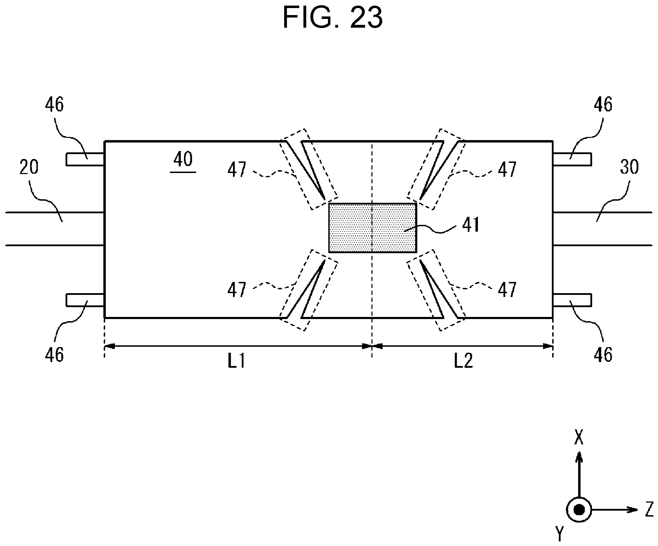

As illustrated in FIG. 23, the light-receiving waveguide 40 may include cutouts 47 between the part where the first input waveguide 20 is connected and the part where the light-receiving unit 41 is installed, and between the part where the second input waveguide 30 is connected and the part where the light-receiving unit 41 is installed. The cutouts 47 are configured to impede the propagation of optical signals other than those that are focused at the light-receiving unit 41, from among optical signals that have propagated from the first input waveguide 20 and the second input waveguide 30. In this way, the intensity of optical signals transmitted through the light-receiving unit 41 can be reduced.

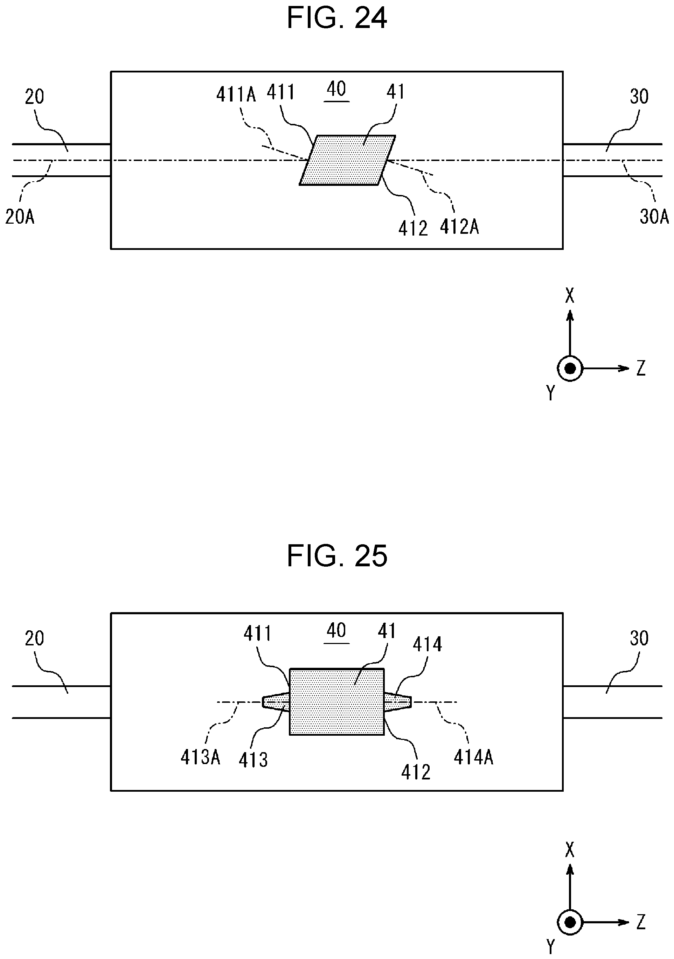

As illustrated in FIG. 24, the light-receiving unit 41 may be configured so that the normal 411A of the end surface 411 thereof on the side connected to the first input waveguide 20 is inclined with respect to the optical axis 20A of the first input waveguide 20. In addition, the light-receiving unit 41 may be configured so that a normal 412A of an end surface 412 thereof on the side connected to the second input waveguide 30 is inclined with respect to an optical axis 30A of the second input waveguide 30. As a result of the end surfaces 411 and 412 of the light-receiving unit 41 being inclined with respect to the optical axes 20A and 30A, the optical signals reflected at the end surfaces 411 and 412 propagate in directions that are offset from the optical axes 20A and 30A, and the optical signals are unlikely to return to the first input waveguide 20 and the second input waveguide 30. Thus, return light caused by reflection of optical signals at the end surfaces 411 and 412 can be reduced.

In addition, as illustrated in FIG. 25, the light-receiving unit 41 may include the protrusion 413 on the end surface 411. In addition, the light-receiving unit 41 may include the protrusion 414 on the end surface 412. The protrusions 413 and 414 may have a reverse taper shape in which the width in the X-axis direction increases as one moves in the direction in which the optical signal propagates (the width in the X-axis direction decreases as one moves in the direction away from the light-receiving unit 41) in plan view (when viewed in the Y-axis direction). Due to the end surfaces 411 and 412 including the protrusions 413 and 414, the optical signals that propagate so as to be input to the light-receiving unit 41 are unlikely to be reflected in the opposite direction from the input direction at the parts of the protrusions 413 and 414 where the width in the X-axis direction is narrow. As a result, the optical signals are unlikely to return to the first input waveguide 20 and the second input waveguide 30.

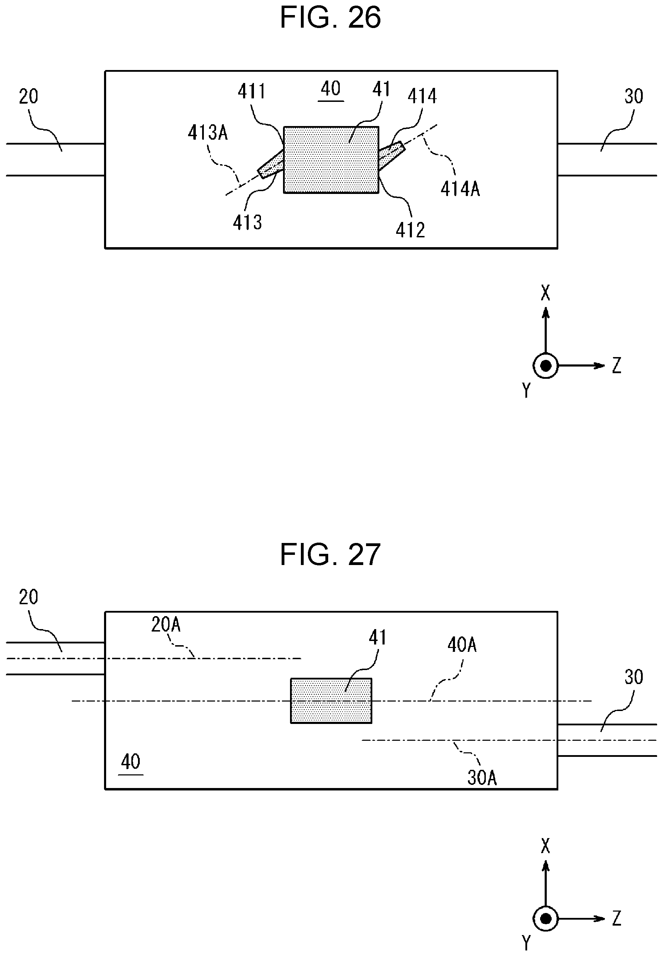

In the example in FIG. 25, the axis 413A of the protrusion 413 is aligned with the direction of the optical axis 20A of the first input waveguide 20 (Z-axis direction). In addition, the axis 414A of the protrusion 414 is aligned with the direction of the optical axis 30A of the second input waveguide 30 (Z-axis direction). As illustrated in FIG. 26, the axis 413A of the protrusion 413 may be inclined with respect to the direction of the optical axis 20A (Z-axis direction). In addition, the axis 414A of the protrusion 414 may be inclined with respect to the direction of the optical axis 30A (Z-axis direction). With this configuration, the optical signals reflected at the tips of the protrusions 413 and 414 propagate in directions offset from the optical axes 20A and 30A, and are unlikely to return to the first input waveguide 20 and the second input waveguide 30.

As illustrated in FIG. 27, the MMI-type photodiode 10 may be configured such that the optical axis 20A of the first input waveguide 20 and the optical axis 30A of the second input waveguide 30 are offset in a direction (X-axis direction) that intersects the propagation direction (Z-axis direction) of the optical signals with respect to a center axis 40A of the light-receiving waveguide 40. In FIG. 27, the light-receiving unit 41 is disposed on the center axis 40A of the light-receiving waveguide 40, but may instead be disposed so as to be offset from the center axis 40A in the width direction (X-axis direction).

As described above, the MMI-type photodiode 10 can reduce return light caused by optical signals passing through the light-receiving unit 41. In addition, the shapes of the end surfaces 411 and 412 may be set so as to reduce return light generated by reflection at the end surfaces 411 and 412 of the light-receiving unit 41.

### <Example of Method of Manufacturing Photodiode 10>

Hereafter, an example of a method of manufacturing the photodiode 10 according to the present disclosure will be described.

As an example of a manufacturing method, the material of the light-receiving waveguide 40, the first input waveguide 20, and the second input waveguide 30 may be silicon, for example. The light-receiving waveguide 40, the first input waveguide 20, and the second input waveguide 30 may be formed by processing the top silicon layer of a silicon-on-insulator (SOI) substrate using photolithography and reactive ion etching. Each waveguide may be formed as a buried channel-type waveguide in which the silicon other than that constituting the waveguide is completely etched away. Each waveguide may be formed as a rib-type optical waveguide in which silicon of a certain thickness remains. After silicon etching, a silicon oxide layer is deposited using chemical vapor deposition. The accumulated silicon oxide layer is planarized by performing chemical mechanical polishing or the like.

Phosphorus ions are implanted into the region where the light-receiving unit 41 is to be formed and the region where the electrode regions 42 are to be formed in the light-receiving waveguide 40 by performing photolithography and ion implantation. Next, the oxide film on the silicon in the region where the light-receiving unit 41 is being formed is removed using photolithography and wet etching using reactive ion etching or hydrofluoric acid.

Epitaxial growth of germanium is carried out using MOVPE (metal-organic vapor phase epitaxy) or another method. In this case, germanium only accumulates in regions where the silicon is exposed. In addition, by changing the dopant used during the epitaxial growth, the germanium layer can be deposited in order from the silicon substrate side as n-type, undoped, and p-type, so as to form a pin diode in the vertical direction relative to the substrate.

In the regions that will become the electrode regions 42 in the light-receiving waveguide 40, the silicon oxide film is removed and phosphorus ions are injected. In addition, boron ions are injected into the upper part of the germanium layer.

A silicon oxide film is deposited using chemical vapor deposition, and then planarized using chemical mechanical polishing. The silicon oxide film on the top of the light-receiving unit 41 and electrode regions 42 is removed using photolithography and reactive ion etching. The via electrodes 45 are formed by embedding tungsten using chemical vapor deposition. In addition, aluminum thin films are deposited by performing sputtering. By processing an aluminum thin film using photolithography and reactive ion etching, wiring lines including the anode electrode 43 and the cathode electrodes 44 are formed.

As another example of a manufacturing method, the light-receiving waveguide 40, the first input waveguide 20, and the second input waveguide 30 are formed on the substrate 50 and the waveguides are buried with a silicon oxide film and planarized, and then a compound semiconductor substrate manufactured in a separate process may be bonded to the substrate 50. The compound semiconductor substrate may be an InP substrate, for example. In the InP substrate, pin layers, which includes InGaAs and InAlGaAs, are formed by performing epitaxial growth using MOVPE as the light-receiving unit 41. A silicon oxide film is deposited on the outermost surface using PECVD (plasma-enhanced chemical vapor deposition), and the surface is planarized using chemical mechanical polishing.

The substrate 50 on which the waveguides have been formed and the InP substrate on which the light-receiving unit 41 has been formed are bonded to each other using a dehydration condensation process. The InP substrate is removed by performing etching using hydrochloric acid or the like. As a result, only the light-receiving unit 41 remains bonded to the substrate 50. As a result of photolithography and reactive ion etching, only the contact layer of the light-receiving unit 41 remains. The contact layer is removed in unwanted areas by photolithography and reactive ion etching or wet etching. By using photolithography and a lift-off process, metal that will become electrodes is deposited on the p- and n-electrodes. As the metal to form the electrodes, a multilayer film such as Au/Pt/Ti, Au/Pt/Ti, or Au/Zn/Ti can be used. A silicon oxide film is deposited using PECVD, and then planarized using CMP (chemical mechanical polishing). Wiring lines including the anode electrode 43 and the cathode electrodes 44 are formed on the silicon oxide film so as to be connected to the via electrodes 45 and the p- and n-electrodes.

### (Example Configuration of Optical Receiver 1)

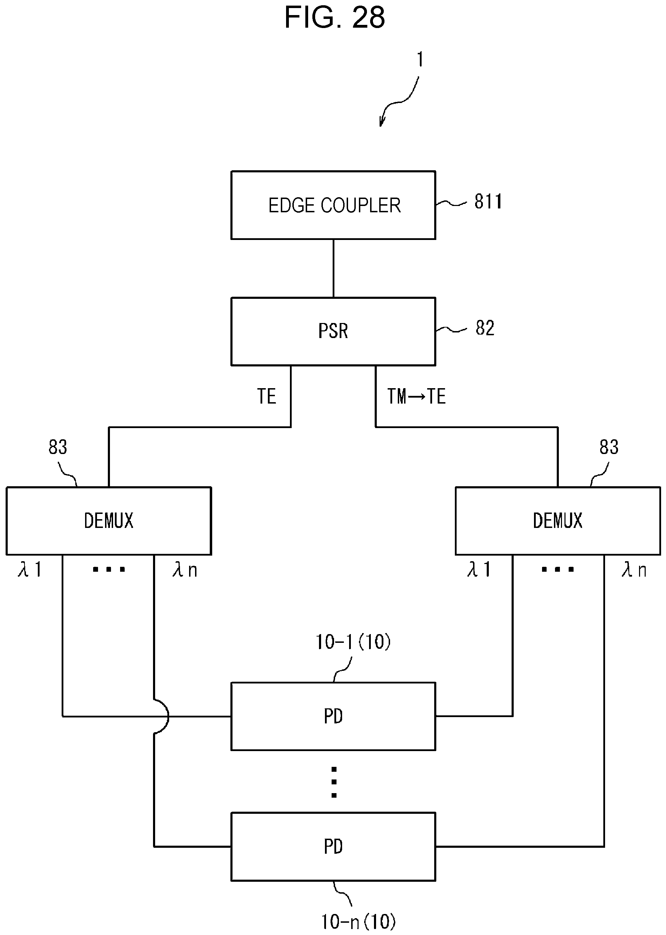

As illustrated in FIG. 28, the optical receiver 1 can be configured using the photodiode 10 according to the present disclosure. The optical receiver 1 includes an edge coupler 811 as the input unit 81. The edge coupler 811 is configured to input light from a chip end surface. The optical receiver 1 also includes a polarizing splitter rotator (PSR) 82 and splitters (DEMUX) 83. Circuits that process an optical signal prior to being input to the photodiode 10 in the optical receiver 1 are collectively referred to as an optical circuit. The optical circuit separates an optical signal input to optical receiver 1 into an optical signal propagating in the TE mode and an optical signal propagating in the TM mode. In the optical receiver 1 according to this embodiment, an optical signal propagating in the TE mode is assumed to correspond to a first optical signal. An optical signal propagating in the TM mode is assumed to correspond to a second optical signal.

In the optical receiver 1, let us assume that an optical signal containing a mixture of a TE-mode optical signal and a TM-mode optical signal and a mixture of n wavelengths is input to the edge coupler 811. The polarizing splitter rotator 82 separates the TE-mode optical signal and the TM-mode optical signal from each other. In addition, the polarizing splitter rotator 82 converts the TM-mode optical signal to a TE-mode optical signal. The splitters 83 further separate each of the optical signals separated by the polarizing splitter rotator 82 into optical signals of n wavelengths.

The photodiodes 10-1 to n are respectively input with signals obtained by separating the TE-mode optical signal by wavelength, and signals obtained by converting the TM-mode optical signal to an TE-mode optical signal and separating the TE-mode optical signal by wavelength. As a result, each of the photodiodes 10-1 to n outputs an electrical signal corresponding to the intensity of a signal separated by wavelength from the optical signal input to the edge coupler 811, which is a mixture of the TE and TM modes.

In this embodiment, the optical receiver 1 may further include a transimpedance amplifier that converts electrical signals output from the photodiodes 10. In this embodiment, the optical receiver 1 can detect optical signals for each wavelength using a single photodiode, compared to the case where two light-receiving elements are used to detect a TE-mode optical signal and a TM-mode optical signal for each wavelength. In this way, faster speeds can be achieved due to reductions in parasitic capacitances, or reductions in power consumption and circuit size can be achieved.

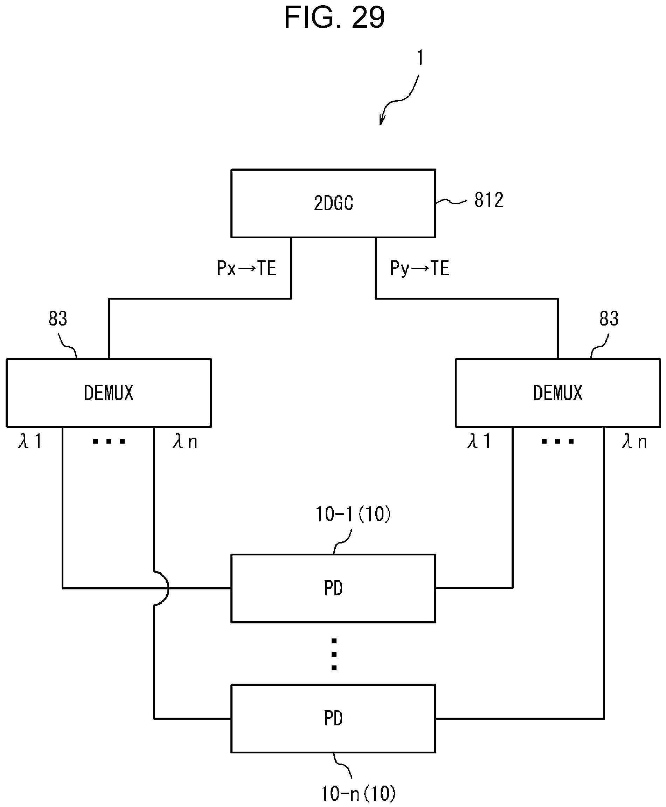

As illustrated in FIG. 29, the optical receiver 1 may include a two-dimensional grating coupler (2DGC: 2-dimensional grating couplers) 812 as the input unit 81. The two-dimensional grating coupler 812 separates the input optical signal into two polarization components Px and Py, and outputs each polarization component as an optical signal having a TE mode polarization. The splitters 83 separate the optical signals of each polarization component by wavelength. The photodiodes 10-1 to n are each input with a signal obtained by separating an optical signal of a polarization component Px by wavelength, and a signal obtained by separating an optical signal of a polarization component Py by wavelength. As a result, each of the photodiodes 10-1 to n outputs an electrical signal corresponding to the intensity of a signal separated by wavelength from the optical signal input to the two-dimensional grating coupler 812, which is a mixture of the TE and TM modes. When the optical receiver 1 includes the two-dimensional grating coupler 812, the optical receiver 1 does not need to include the polarizing splitter rotator 82.

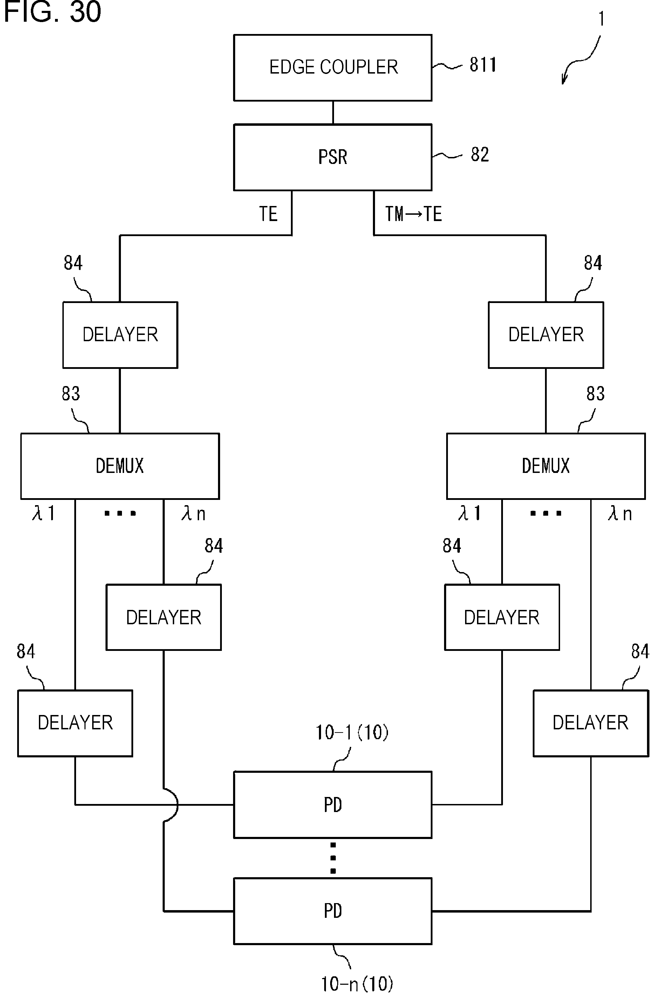

As illustrated in FIG. 30, the optical receiver 1 may further include delayers 84 between the polarizing splitter rotator 82 and each of the two splitters 83, and between the splitters 83 and each of the n photodiodes 10-1 to n. The delayers 84 delay the propagation of optical signals. The optical receiver 1 compensates for variations between the delays in the optical signals caused by manufacturing errors in the waveguides using the delayers 84. As a result of the optical receiver 1 including the delayers 84, jitter of combined signals consisting of a TE-mode optical signal and a TE-mode optical signal converted from the TM-mode optical signal output from the photodiodes 10 can be reduced.

The delayers 84 may be, for example, configured as waveguides having a prescribed length, and the effective refractive index of the waveguides may be adjustable using a heater. The delayers 84 may be configured as phase modulators having a prescribed length and may be configured so that the amount of phase modulation can be adjusted by applying a voltage.

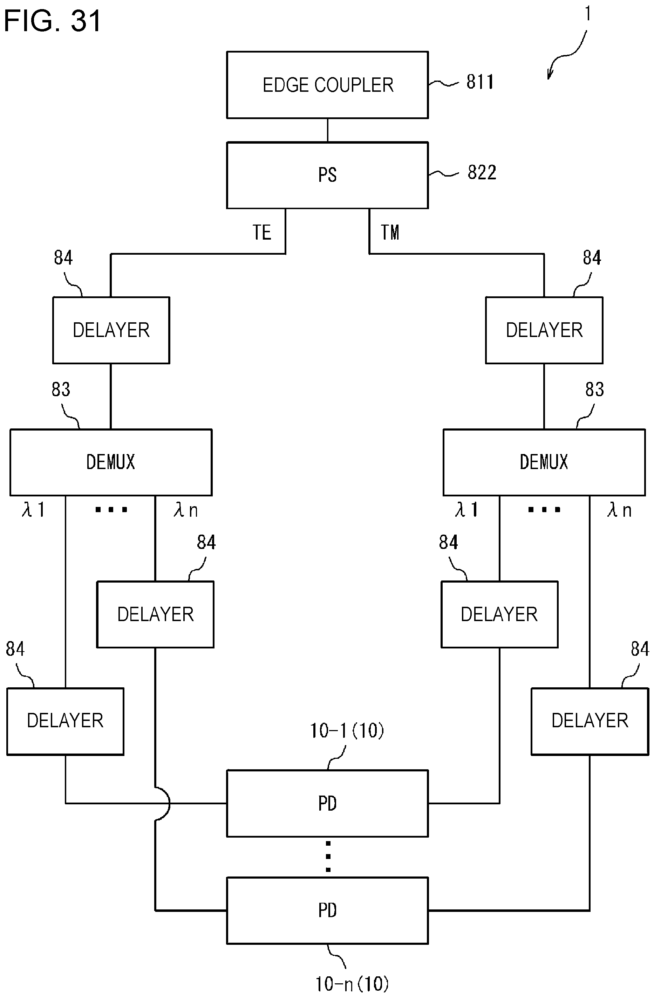

As illustrated in FIG. 31, the polarizing splitter rotator 82 in the optical receiver 1 may be replaced with a polarizing splitter (PS) 822. The polarizing splitter 822 splits an input optical signal into a TE-mode optical signal and a TM-mode optical signal. The TE-mode optical signal and the TM-mode optical signal have different propagation speeds from each other. The optical receiver 1 may include the delayers 84 to compensate for differences in delay between the TE-mode optical signal and the TM-mode optical signal.

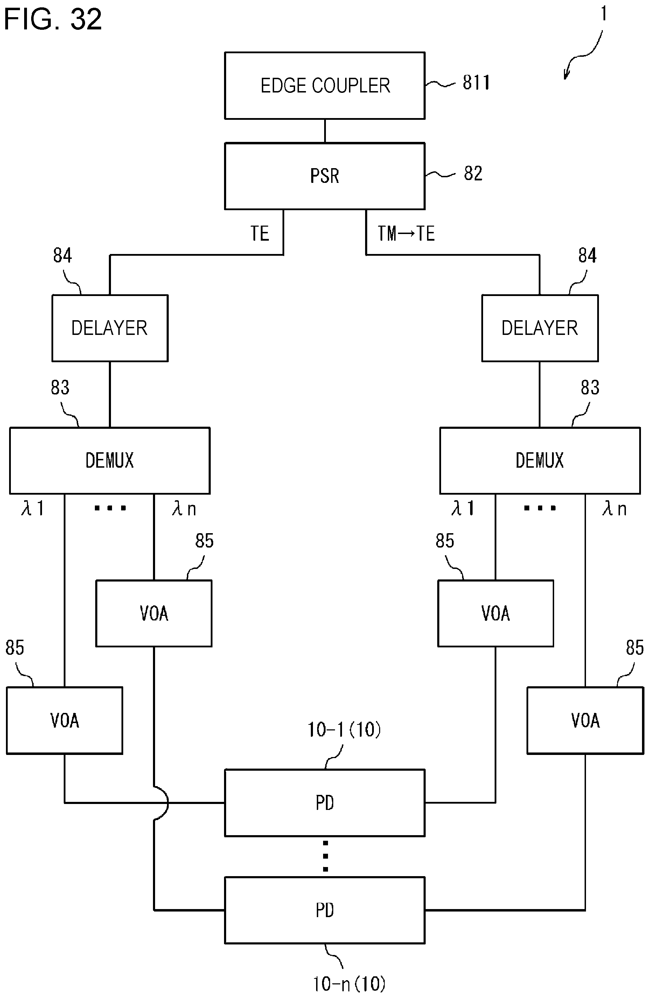

As illustrated in FIG. 32, the delayers 84 connected between the splitters 83 and each of the n photodiodes 10-1 to n in the optical receiver 1 illustrated in FIG. 28 may be replaced with variable optical attenuators (VOAs) 85. The variable optical attenuators 85 may include silicon pin diodes, for example. The variable optical attenuators 85 absorb light and attenuate light intensity by being injected with a current. By adjusting the current injected into each variable optical attenuator 85, the optical loss that occurs in the polarizing splitter rotator 82 or the splitter 83 can be compensated for. Therefore, even if optical loss in the polarizing splitter rotator 82 or the splitters 83 is not uniform due to differences in the polarization or wavelength of the optical signals, the light-reception sensitivity of optical signals with any polarization or wavelength can be made to approach uniformity by decreasing the current values of the variable optical attenuators 85 through which optical signals having high optical loss pass and increasing the current values of the variable optical attenuators 85 through which optical signals having low optical loss pass.

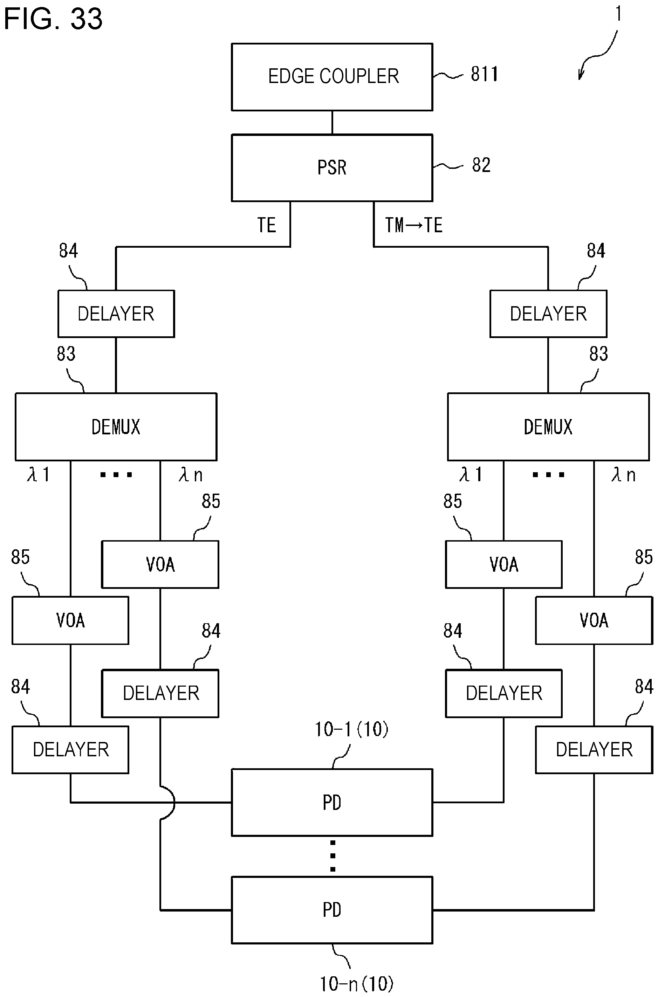

As illustrated in FIG. 33, the optical receiver 1 may include both variable optical attenuators 85 and delayers 84 between the splitters 83 and each of the n photodiodes 10-1 to n.

As described above, in this embodiment, the optical receiver 1 can detect an optical signal using the photodiodes 10 configured to reduce return light. Optical signals returning to the input unit 81 can be reduced as a result of the return light being reduced. Stable operation of a light source or modulator that transmits an optical signal to the input unit 81 can be maintained by reducing optical signals returning to the input unit 81. As a result, the reliability of an optical communication system using the optical receiver 1 can be improved.

### <Optical Detection Devices>

In the present disclosure, the photodiodes 10 are used as optical detection devices that detect optical signals. As optical detection devices, other light-receiving elements such as phototransistors may be used instead of the photodiodes 10. Even when other light-receiving elements are used as optical detection devices, the reliability of optical communication systems can be improved by employing a configuration so that the amount of return light is reduced.

Although embodiments of the present disclosure have been described based on the drawings and examples, please note that one skilled in the art can make various variations or changes based on the present disclosure. Please note that, therefore, these variations or changes are included within the scope of the present disclosure. For example, the functions and so on included in each constituent part can be rearranged in a logically consistent manner, and multiple constituent parts and so on can be combined into one part or divided into multiple parts. Please understand that the scope of the present disclosure encompasses these forms.

In the present disclosure, "first", "second", and so on are identifiers used to distinguish between such configurations. Regarding the configurations, "first", "second", and so on used to distinguish between the configurations in the present disclosure may be exchanged with each other. For example, identifiers "first" and "second" may be exchanged between the first input waveguide 20 and the second input waveguide 30. Exchanging of the identifiers take places simultaneously. Even after exchanging the identifiers, the configurations are distinguishable from each other. The identifiers may be deleted. The configurations that have had their identifiers deleted are distinguishable from each other by symbols. Just the use of identifiers such as "first" and "second" in this disclosure is not to be used as a basis for interpreting the order of such configurations or the existence of identifiers with smaller numbers.

In the present disclosure, the X-axis, the Y-axis, and the Z-axis are provided for convenience of explanation and may be interchanged with each other. The configurations of the present disclosure have been described using a Cartesian coordinate system consisting of the X-axis, the Y-axis, and the Z axis. The positional relationship between configurations in the present disclosure is not limited to a Cartesian relationship.

### REFERENCE SIGNS

1 optical receiver (81: input unit, 811: edge coupler, 812: two-dimensional grating coupler (2DGC), 82: polarizing splitter rotator (PSR), 822: polarizing splitter (PS), 83: demultiplexer (DEMUX), 84: delayer, 85: variable optical attenuator (VOA))
10 photodiode
20 first input waveguide (20A: optical axis, 22: tapered portion)
30 second input waveguide (30A: optical axis, 32: tapered portion)
40 light-receiving waveguide (40A: center axis, 41: light-receiving unit, 411, 412: end surface, 413, 414: protrusion, 42: electrode region, 43: anode electrode, 44: cathode electrode, 45: via electrode, 46: terminating waveguide, 47: cutout)
50 substrate (51 to 53: first to third insulating layers)

## Claims

1. An optical detection device comprising:
a light-receiving waveguide connected to a first input waveguide input with a first optical signal and a second input waveguide input with a second optical signal; and
a light-receiving unit configured to output an electrical signal corresponding to an intensity of a signal obtained by combining the first optical signal and the second optical signal input to the light-receiving waveguide,
wherein the light-receiving unit is configured to reduce an intensity of an optical signal returning in an opposite direction from a first direction in which the first optical signal propagates in the first input waveguide, and an intensity of an optical signal returning in an opposite direction from a second direction in which the second optical signal propagates in the second input waveguide.

2. The optical detection device according to claim 1, wherein the light-receiving waveguide is a multimode interference type waveguide.

3. The optical detection device according to claim 2, wherein the light-receiving waveguide is connected to the first input waveguide so that a width of the first input waveguide and a width of the light-receiving waveguide change in a discontinuous manner along the first direction, and the light-receiving waveguide is connected to the second input waveguide so that a width of the second input waveguide and the width of the light-receiving waveguide change in a discontinuous manner along the second direction.

4. The optical detection device according to claim 3, wherein a rate of change of the width of the light-receiving waveguide relative to the width of each of the first input waveguide and the second input waveguide is greater than or equal to a prescribed value.

5. The optical detection device according to any one of claims 2 to 4, wherein the light-receiving waveguide includes at least one of a first terminating waveguide connected to an opposite side of the light-receiving waveguide from the first input waveguide along the first direction, or a second terminating waveguide connected to an opposite side of the light-receiving waveguide from the second input waveguide along the second direction.

6. The optical detection device according to any one of claims 1 to 5, wherein the first direction and the second direction are approximately parallel to each other.

7. The optical detection device according to any one of claims 1 to 5, wherein an angle between the first direction and the second direction lies within a prescribed range including 90 degrees.

8. The optical detection device according to any one of claims 1 to 7,
wherein the light-receiving unit has a first surface located at a side in the first direction and a second surface located at a side in the second direction,
at least part of the first surface includes a surface having a normal direction that is not parallel to the first direction, and
at least part of the second surface includes a surface having a normal direction that is not parallel to the second direction.

9. An optical receiver comprising:
an optical circuit configured to separate an input optical signal into a first optical signal propagating in a TE mode and a second optical signal propagating in a TM mode; and
an optical detection device configured to output an electrical signal corresponding to an intensity of the first optical signal and the second optical signal input from the optical circuit;
a light-receiving waveguide connected to a first input waveguide to which the first optical signal is input and a second input waveguide to which the second optical signal is input; and
a light-receiving unit configured to output an electrical signal corresponding to an intensity of a signal obtained by combining the first optical signal and the second optical signal input to the light-receiving waveguide,
wherein the light-receiving unit is configured to reduce an intensity of an optical signal returning in an opposite direction from a first direction in which the first optical signal propagates in the first input waveguide, and an intensity of an optical signal returning in an opposite direction from a second direction in which the second optical signal propagates in the second input waveguide.

10. The optical receiver according to claim 9, wherein the optical circuit includes an edge coupler configured to accept input of an optical signal, a polarizing splitter rotator configured to separate the optical signal input to the edge coupler into the first optical signal and the second optical signal and convert the second optical signal from the TM mode to the TE mode, and a splitter configured to separate the first optical signal and the second optical signal into optical signals for each wavelength.

11. The optical receiver according to claim 9, wherein the optical circuit includes a two-dimensional grating coupler configured to accept input of an optical signal, separate the optical signal into the first optical signal and the second optical signal, and convert the second optical signal from the TM mode to the TE mode, and a splitter configured to separate the first optical signal and the second optical signal into optical signals for each wavelength.

12. The optical receiver according to claim 10 or 11, wherein the optical circuit further includes a delayer.

13. The optical receiver according to claim 12, wherein the optical circuit further includes a variable optical attenuator.
